# EUROPEAN PATENT SPECIFICATION

(11) **EP 2 160 730 B1**
(45) Date of publication and mention of the grant of the patent: **12.06.2013**
(21) Application number: 08756488.6
(22) Date of filing: 30.05.2008
(51) Int. Cl.: G09G 3/34, H01L 27/32, H01L 31/042

(54) **METHOD OF MANUFACTURING ADDRESSABLE AND STATIC ELECTRONIC DISPLAYS, POWER GENERATING OR OTHER ELECTRONIC APPARATUS**
VERFAHREN ZUR HERSTELLUNG VON ADRESSIERBAREN UND STATISCHEN ELEKTRONISCHEN ANZEIGEN, STROMERZEUGUNGS- UND/ODER ANDEREN ELEKTRONISCHEN VORRICHTUNGEN
PROCÉDÉ DE FABRICATION D'AFFICHAGE ÉLECTRONIQUE ADRESSABLE STATIQUE ET D'UN APPAREIL GÉNÉRANT DE LA PUISSANCE OU AUTRE APPAREIL ÉLECTRONIQUE

(30) Priority: 31.05.2007 US 756619; 31.05.2007 US 756616
(43) Date of publication of application: 10.03.2010
(73) Proprietor: Nthdegree Technologies Worldwide Inc., Tempe, AZ 85284 (US)
(72) Inventor: RAY, William, Johnstone, Fountain Hills, AZ 85268 (US); LOWENTHAL, Mark, D., Gilbert, AZ 85297 (US); BOWDEN, David, R., Springboro, OH 45066 (US); SHOTTON, Neil, O., Tempe, AZ 85284 (US)
(74) Representative: Perkins, Sarah
(86) International application number: PCT/US2008/065237
(87) International publication number: WO 2008/150965

(56) References cited:
- WO-A2-99/67678
- US-A- 5 793 455
- US-A- 6 046 543
- US-A1- 2002 195 928
- US-A1- 2007 035 808
- US-B1- 6 407 763
- US-B1- 6 780 696
- US-B2- 6 864 875
- US-B2- 7 095 477
- US-B2- 7 218 048

## Description

### FIELD OF THE INVENTION

The present invention in general is related to electronic display technology and, in particular, is related to an electronic display or power generating technology capable of being printed or coated on a wide variety of substrates, and which further may be electronically addressable in various forms for real-time display of information.

### BACKGROUND OF THE INVENTION

Display technologies have included television cathode ray tubes, plasma displays, and various forms of flat panel displays. Typical television cathode ray tube displays utilize an emissive coating, typically referred to as a "phosphor" on an interior, front surface, which is energized from a scanning electron beam, generally in a pattern referred to as a raster scan. Such television displays have a large, very deep form factor, making them unsuitable for many purposes.

Other displays frequently used for television, such as plasma displays, while having a comparatively flat form factor, involve a complex array of plasma cells containing a selected gas or gas mixture. Using row and column addressing to select a picture element (or pixel), as these cells are energized, the contained gas is ionized and emits ultraviolet radiation, causing the pixel or subpixel containing a corresponding color phosphor to emit light. Involving myriad gas-containing and phosphor-lined cells, these displays are complicated and expensive to manufacture, also making them unsuitable for many purposes.

Other newer display technologies, such as active and passive matrix liquid crystal displays ("LCDs"), also include such pixel addressability, namely, the capability of individually addressing a selected picture element. Such displays include a complex array of layers of transistors, LCDs, vertically polarizing filters, and horizontally polarizing filters. In such displays, there is often a light source which is always powered on and emitting light, with the light actually transmitted controlled by addressing particular LCDs within an LCD matrix. Such addressing, however, is accomplished through additional layers of transistors, which control the on and off state of a given pixel.

Currently, creation of such displays or power generators requires semiconductor fabrication techniques to create the controlling transistors, among other things. A wide variety of technologies are involved to fabricate the liquid crystal layer and various polarizing layers. LCD displays also are complicated and expensive to manufacture and, again, unsuitable for many purposes.

As a consequence, a need remains for a scalable electronic display, which may provide substantially larger form factors, suitable for applications such as outdoor signage. In addition, for various applications, such an electronic display should provide a printable surface, for direct application of an image to be illuminated. Such an electronic display should also provide for significant durability with a capability to withstand typical environmental conditions, especially for outdoor applications or other applications in environments having variable conditions. Another version of the electronic apparatus should provide for power generation capability, such as by using photovoltaic diodes.

A further need remains for a dynamic electronic display which provides for pixel addressability, for the display of dynamically changing information. Such a display further should be capable of fabrication using printing or coating technologies, rather than using complicated and expensive semiconductor fabrication techniques. Such a display should be capable of fabrication in a spectrum of sizes, from a size comparable to a mobile telephone display, to that of a billboard display (or larger). Such a display should also be robust and capable of operating under a wide variety of conditions.

WO 99/67678 discloses a display media using a type of electronic ink (e-ink) with capsules of pigments or other particles capable of acquiring a charge in a suspending fluid such as an organic solvent. This display media is coupled to electronic driving circuitry, which may be comprised of diodes or transistors (nonlinear elements). During device operation, an applied electrical field provided by the electrodes of the driving circuitry moves the pigment particles in the capsules, creating an image on the display. An electric or a magnetic field is not applied at any time during device fabrication.

U.S. Patent Application Publication No. 2002/0195928 discloses embossed protrusions or ridges in a substrate for holding polymer light emitting diodes or organic light emitting diodes.

U.S. Patent No. 6,046,543 discloses a substrate having recesses into which layers of an inverted organic light emitting diode are fabricated.

U.S. Patent No. 6,780,696 utilizes a "lock and key" method (similar to WO 99/67678) to fabricate self-assembled diode microstructures, and discloses trapezoidal recesses in a substrate into which functional blocks of trapezoidal electronic devices dispersed in a slurry are deposited, with the slurry consisting of typical gases, solvents, with surfactant additives.

### SUMMARY OF THE INVENTION

The present invention provides a method of manufacturing an electronic apparatus according to claim 1.

The exemplary embodiments of the present invention provide a new type of electronic display and a new method of manufacturing such a display, using printing and coating technologies. The inventive electronic display may be regional or static, such as for signage, or which may be addressable, such as for the display of changing information. The inventive display may be fabricated in a wide variety of sizes, from a size comparable to a mobile telephone display, to that of a billboard display (or larger). The exemplary inventive displays are also robust and capable of operating under a wide variety of conditions, including outdoor and other stressful environmental conditions. Another version of the electronic apparatus provides for power generation capability, such as by using photovoltaic diodes. Yet another version of the electronic apparatus provides for a lighting apparatus, such as by using light emitting diodes.

In an exemplary embodiment, a method of manufacturing an electronic apparatus is provided.

For selected exemplary embodiments, the substrate has a plurality of cavities, which may be integrally molded in the substrate. For various applications, the substrate may be embossed. For these embodiments, the step of depositing the first conductive medium further comprises depositing the first conductive medium in the plurality of cavities to form a plurality of first conductors. The plurality of cavities may be at least one of the following types of cavities: channels, grooves, or substantially hemispherically-shaped depressions or bores. The step of depositing the second conductive medium may also further comprise depositing the second conductive medium to form a plurality of second conductors. The exemplary method may also further comprise depositing a third conductive medium over or within the plurality of second conductors.

Also for selected exemplary embodiments, the step of depositing the first conductive medium further comprises coating the plurality of cavities with the first conductive medium and removing excess first conductive medium by scraping a surface of the substrate using a doctor blade. Similarly, the step of depositing the plurality of electronic components further comprises coating the plurality of cavities with the plurality of electronic components and removing excess plurality of electronic components by scraping a surface of the substrate using a doctor blade.

The plurality of electronic components are suspended in a binding medium, which is be cured while the plurality of electronic components are oriented by the applied field. The cured binding medium has a dielectric constant greater than about one, to provide at least some degree of electrical insulation for a selected application. Exemplary curing steps include (1) curing the binding medium using a substantially uniform and substantially constant applied electromagnetic field; (2) curing the binding medium using an applied ultraviolet electromagnetic field; and/or (3) curing the binding medium using an applied visible spectrum electromagnetic field.

In another exemple, not forming part of the invention, the plurality of electronic components are suspended in a solvent. For this embodiment, the exemplary method further comprises evaporating the solvent; and binding the plurality of electronic components to the plurality of first conductors while the plurality of electronic components are oriented by the applied field.

For selected embodiments, the exemplary method may further comprise bonding the plurality of electronic components to the first conductor, such as by abutment to or within the first conductor, or by annealing the plurality of electronic components to the first conductor.

In an exemplary embodiment, the first conductive medium is a conductive ink, which may be cured using applied ultraviolet radiation or applied heat. Also in an exemplary embodiment, the second conducting medium is an optically transmissive polymer.

The applied field is, a magnetic field, or an electromagnetic field, for example. In addition, the exemplary method may further comprise applying a sonic field subsequent to or during the deposition of the plurality of electronic components, or vibrating the substrate subsequent to or during the deposition of the plurality of electronic components.

In an exemplary embodiment, the deposition steps further comprise at least one of the following types of deposition: printing, coating, rolling, spraying, layering, sputtering, lamination, screen printing, inkjet printing, electro-optical printing, electroink printing, photoresist printing, thermal printing, laser jet printing, magnetic printing, pad printing, flexographic printing, hybrid offset lithography, Gravure printing, and/or printing.

The second, optically transmissive conductive medium forms a second conductor and an other exemplary method further comprises depositing a third conductive medium over or within the second conductor.

The plurality of electronic components are any type or kind of diode, such as light emitting diodes ("LEDs") or photovoltaic diodes, for example. The electronic apparatus may be an addressable light emitting diode display, a static or regionally-addressable light emitting diode display, or a lighting apparatus, for example. The electronic apparatus also may be a generator of electrical power, such as by using photovoltaic diodes, also for example. The plurality of electronic components may be comprised of any suitable materials, such as silicon-based photovoltaic diodes or gallium arsenide-based .LEDs, for example and without limitation.

The plurality of electronic components may also be provided in various shapes or sizes which are more suitable for alignment in the applied field, such as tall and thin (e.g., 100 microns by 18-20 microns by 20-40 microns); or "mushroom" shaped, with a wider, rounded top above a tower-shaped, lower portion; or an inverse-mushroom shape, with a rounded bottom portion which tends to roll or swivel into an upright position, etc. Those of skill in the art will recognize that a wider variety of shapes, sizes, and compositions are available for the plurality of electronic components, and all are within the scope of the present invention, with a size, shape, or composition selected for any given application, for example.

The substrate may be substantially flat and have a thickness of less than two millimeters. For example, the substrate may comprise at least one of the following types of substrates: paper, coated paper, plastic coated paper, embossed paper, fiber paper, cardboard, poster paper, poster board, wood, plastic, rubber, fabric, glass, ceramic, concrete, or stone.

The plurality of cavities may be substantially elongated and have the first orientation. Alternatively, the plurality of cavities may be substantially and partially hemispherically-shaped and are disposed in an array. For this latter embodiment, the plurality of first conductors may further comprise a first portion substantially disposed within the plurality of cavities; and a second portion substantially elongated and disposed in the first orientation.

In an exemplary embodiment, the plurality of first conductors may comprise a cured conductive ink or a cured conductive polymer. For example, the plurality of first conductors may comprise at least one of the following types of conductors in a cured form: a silver conductive ink, a copper conductive ink, a gold conductive ink, an aluminum conductive ink, a tin conductive ink, a carbon conductive ink, or a conductive polymer. Similarly, the plurality of second conductors may comprise an optically transmissive polymer. For example, the plurality of second conductors may comprise at least one of the following types of optically transmissive polymers: antimony tin oxide, indium tin oxide, or polyethylene-dioxithiophene.

In various exemplary embodiments, the plurality of light emitting or other type of diodes may be coupled to or within the plurality of first conductors by abutment, or may be annealed to or within the plurality of first conductors. In addition, the plurality of first conductors, the plurality of light emitting or other type of diodes and the plurality of second conductors may be deposited through a printing process. In addition, the various diodes may be asymmetrically shaped to have a mushroom form, or an inverted-mushroom form, or a tower form, for example.

In such exemplary embodiments, the substrate may have a plurality of cavities which are substantially elongated and substantially parallel within the first orientation, or the substrate may have a plurality of cavities which are substantially and partially hemispherically-shaped and are disposed in an array. The first conductor may also further comprise a plurality of first conductors, each of the first conductors having a first portion substantially disposed within the plurality of cavities; and a second portion substantially elongated and substantially parallel within the first orientation. In another embodiment, the first conductor may further comprise a plurality of substantially parallel first conductors, and the second conductor may further comprises a plurality of second conductors, each of the second conductors substantially parallel and substantially perpendicular to the plurality of first conductors.

Numerous other advantages and features of the present invention will become readily apparent from the following detailed description of the invention and the embodiments thereof, from the claims and from the accompanying drawings.

### BRIEF DESCRIPTION OF THE DRAWINGS

The objects, features and advantages of the present invention will be more readily appreciated upon reference to the following disclosure when considered in conjunction with the accompanying drawings, wherein like reference numerals are used to identify identical components in the various views, and wherein reference numerals with alphabetic characters are utilized to identify additional types, instantiations or variations of a selected component embodiment in the various views, in which:
Figure (or "FIG.") 1 is a perspective view of a first exemplary substrate 100 for an apparatus embodiment in accordance with the teachings of the present invention.
Figure (or "FIG.") 2 is a cross-sectional view of the first exemplary substrate 100 for an apparatus embodiment in accordance with the teachings of the present invention.
Figure (or "FIG.") 3 is a perspective view of a first exemplary substrate with a plurality of first conductors having been deposited for an apparatus embodiment in accordance with the teachings of the present invention.
Figure (or "FIG.") 4 is a cross-sectional view of the first exemplary substrate with a plurality of first conductors for an apparatus embodiment in accordance with the teachings of the present invention.
Figure (or "FIG.") 5 is a perspective view of a first exemplary substrate 100 with a plurality of first conductors and a plurality of electronic components having been deposited for an apparatus embodiment in accordance with the teachings of the present invention.
Figure (or "FIG.") 6 is a cross-sectional view of the first exemplary substrate with a plurality of first conductors and a plurality of electronic components having been deposited for an apparatus embodiment in accordance with the teachings of the present invention.
Figure (or "FIG.") 7 is a cross-sectional view with an electronic equivalent circuit element of an exemplary electronic components oriented in an applied field for an apparatus embodiment in accordance with the teachings of the present invention.
Figure (or "FIG.") 8 is a perspective view of a second exemplary substrate for an apparatus embodiment in accordance with the teachings of the present invention.
Figure (or "FIG.") 9 is a cross-sectional view of the second exemplary substrate for an apparatus embodiment in accordance with the teachings of the present invention.
Figure (or "FIG.") 10 is a perspective view of a second exemplary substrate 200 with a plurality of first conductors having been deposited for an apparatus embodiment in accordance with the teachings of the present invention.
Figure (or "FIG.") 11 is a cross-sectional view of the second exemplary substrate with a plurality of first conductors for an apparatus embodiment in accordance with the teachings of the present invention.
Figure (or "FIG.") 12 is a perspective view of a second exemplary substrate with a plurality of first conductors having been deposited for an apparatus embodiment in accordance with the teachings of the present invention.
Figure (or "FIG.") 13 is a cross-sectional view of the second exemplary substrate with a plurality of first conductors having been deposited for an apparatus embodiment in accordance with the teachings of the present invention.
Figure (or "FIG.") 14 is a perspective view of a second exemplary substrate with a plurality of first conductors and a plurality of electronic components having been deposited for an apparatus embodiment in accordance with the teachings of the present invention.
Figure (or "FIG.") 15 is a cross-sectional view of the second exemplary substrate with a plurality of first conductors and a plurality of electronic components having been deposited for an apparatus embodiment in accordance with the teachings of the present invention.
Figure (or "FIG.") 16 is a first cross-sectional view of a second exemplary apparatus embodiment in accordance with the teachings of the present invention.
Figure (or "FIG.") 17 is a perspective view of a first exemplary apparatus embodiment in accordance with the teachings of the present invention.
Figure (or "FIG.") 18 is a perspective view of a second exemplary apparatus embodiment in accordance with the teachings of the present invention.
Figure (or "FIG.") 19 is a perspective view of a third exemplary apparatus embodiment in accordance with the teachings of the present invention.
Figure (or "FIG.") 20 is a first cross-sectional view of the first exemplary apparatus embodiment in accordance with the teachings of the present invention.
Figure (or "FIG.") 21 is a second cross-sectional view of the first exemplary apparatus embodiment in accordance with the teachings of the present invention.
Figure (or "FIG.") 22 is a second cross-sectional view of a second exemplary apparatus embodiment in accordance with the teachings of the present invention.
Figure (or "FIG.") 23 is a cross-sectional view of a fourth exemplary apparatus embodiment in accordance with the teachings of the present invention.
Figure (or "FIG.") 24 is a cross-sectional view of a fifth exemplary apparatus embodiment in accordance with the teachings of the present invention.
Figure (or "FIG.") 25 is a cross-sectional view of a sixth exemplary apparatus embodiment in accordance with the teachings of the present invention.
Figure (or "FIG.") 26 is a cross-sectional view of a seventh exemplary apparatus embodiment in accordance with the teachings of the present invention.
Figure (or "FIG.") 27 is a cross-sectional view of a third exemplary apparatus embodiment in accordance with the teachings of the present invention.
Figure (or "FIG.") 28 is a cross-sectional view of a third exemplary apparatus embodiment in accordance with the teachings of the present invention.
Figure (or "FIG.") 29 is a block diagram illustrating a system embodiment in accordance with the teachings of the present invention.
Figure (or "FIG.") 30 is a flow chart illustrating a method embodiment in accordance with the teachings of the present invention.

### DETAILED DESCRIPTION OF EXEMPLARY EMBODIMENTS

While the present invention is susceptible of embodiment in many different forms, there are shown in the drawings and will be described herein in detail specific exemplary embodiments thereof, with the understanding that the present disclosure is to be considered as an exemplification of the principles of the invention and is not intended to limit the invention to the specific embodiments illustrated. In this respect, before explaining at least one embodiment consistent with the present invention in detail, it is to be understood that the invention is not limited in its application to the details of construction and to the arrangements of components set forth above and below, illustrated in the drawings, or as described in the examples. Methods and apparatuses consistent with the present invention are capable of other embodiments and of being practiced and carried out in various ways. Also, it is to be understood that the phraseology and terminology employed herein, as well as the abstract included below, are for the purposes of description and should not be regarded as limiting.

For selected embodiments, the invention disclosed herein is related to United States Patent Application Serial No. 11/023,064, filed December 27, 2004, inventors William Johnstone Ray et al., entitled "Addressable And Printable Emissive Display", to United States Patent Application Serial No. 11/181,488, filed July 13, 2005, inventors William Johnstone Ray et al., entitled "Addressable And Printable Emissive Display", and to United States Patent Application Serial No. 11/485,031, filed July 12, 2006, inventors William Johnstone Ray et al., entitled "Static and Addressable Emissive Displays" (the "related applications") which are commonly assigned herewith, the contents of all of which are incorporated herein by reference in their entireties, and with priority claimed for all commonly disclosed subject matter.

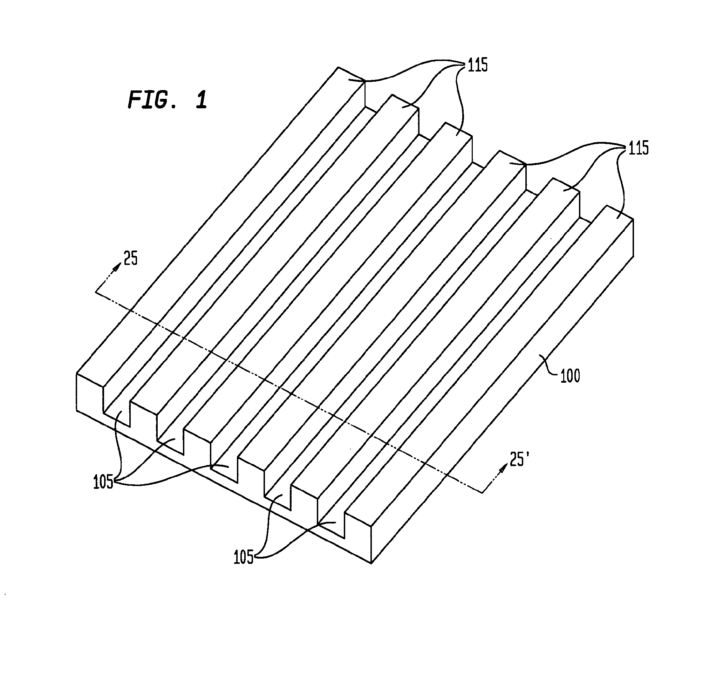

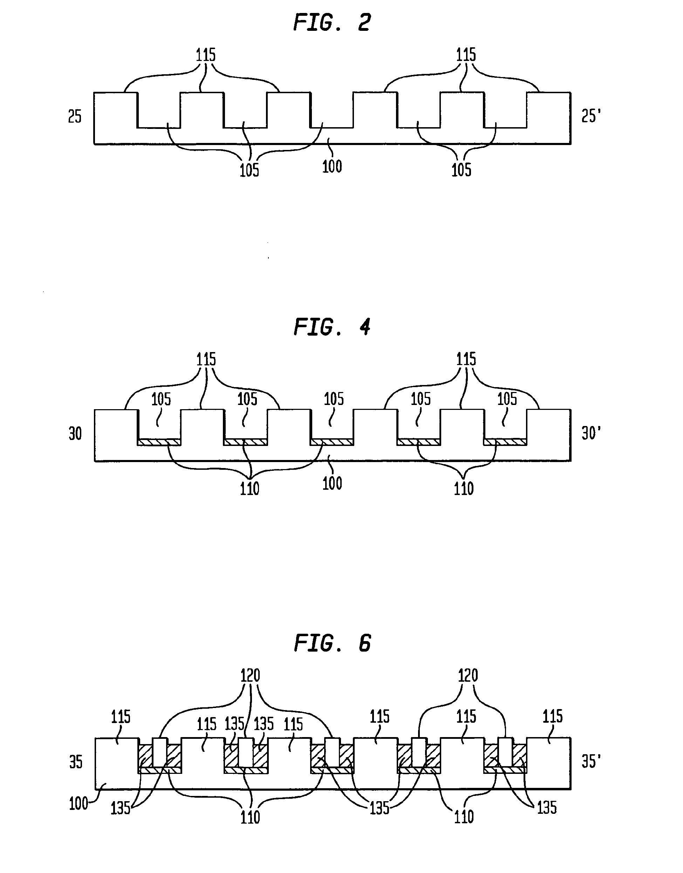

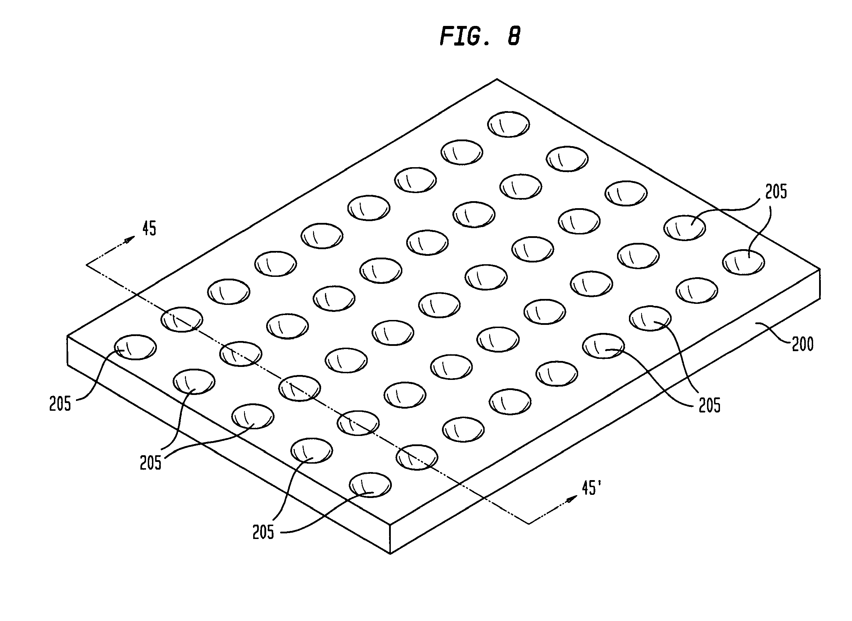

Figure 1 is a perspective view of a first exemplary substrate 100 for an apparatus embodiment 175, 185 in accordance with the teachings of the present invention. Figure 2 is a cross-sectional view (through the 25-25' plane) of the first exemplary substrate 100 for an apparatus embodiment 175, 185 in accordance with the teachings of the present invention. It should be noted that any reference to apparatus 175 should be understood to mean and include its variants, and vice-versa, including apparatuses 175A, 175B, 175C, and 175D, discussed below. As illustrated in Figures 1 and 2, the substrate 100 includes a plurality of cavities (or voids) 105, which for the selected embodiment, are formed as elongated cavities, effectively forming channels, grooves or slots (or, equivalently, depressions, valleys, bores, openings, gaps, orifices, hollows, slits, or passages). Another cavity 105 embodiment is discussed below with reference to Figure 8, which illustrates a plurality of cavities 105 which are shaped to be substantially circular or elliptical depressions or bores 205, forming a substrate 200 (which differs from substrate 100 only due to the shape of the cavities 205). Accordingly, any reference herein to cavities 105 or 205 shall be understood to mean and include the other, or any other cavity of any shape or size. The plurality of cavities 105, 205 are spaced-apart, and which will be utilized to shape and define a plurality of first conductors, as discussed below. In addition, the plurality of cavities 105, 205 may also be utilized to define a "holding well" for color selection (*e.g*., for red, green or blue LEDs 120A, also discussed below). While the cavities or channels 105 are illustrated in Figure 1 as substantially parallel and oriented in the same direction, those having skill in the art will recognize that innumerable variations are available, including depth and width of the channels, channel orientation (*e.g*., circular, elliptical, curvilinear, wavy, sinusoidal, triangular, fanciful, artistic, etc.), spacing variations, type of void or cavity (*e.g*., channel, depression or bore), etc., and all such variations are considered equivalent and within the scope of the present invention. Substrates 100, 200 having additional forms are illustrated and discussed below with reference to Figures 8 - 16, 18, 19, 22 - 25, 27 and 28.

The substrate 100, 200 may be formed from or comprise any suitable material, such as plastic, paper, cardboard, or coated paper or cardboard, for example and without limitation. In an exemplary embodiment, the substrate 100, 200 comprises an embossed and coated paper or plastic having the plurality of cavities 105, 205 formed integrally therein, such as through a molding process, including an embossed paper or embossed paper board commercially available from Sappi, Ltd., for example. The substrate substrate 100, 200 may comprise, also for example, any one or more of the following: paper, coated paper, plastic coated paper, fiber paper, cardboard, poster paper, poster board, books, magazines, newspapers, wooden boards, plywood, and other paper or wood-based products in any selected form; plastic materials in any selected form (sheets, film, boards, and so on); natural and synthetic rubber materials and products in any selected form; natural and synthetic fabrics in any selected form; glass, ceramic, and other silicon or silica-derived materials and products, in any selected form; concrete (cured), stone, and other building materials and products; or any other product, currently existing or created in the future. In a first exemplary embodiment, a substrate 100, 200 may be selected which provides a degree of electrical insulation (*i.e*., has a dielectric constant or insulating properties sufficient to provide electrical isolation of the plurality of first conductors .110 deposited or applied on that (first) side of the apparatus 175, and its variants 175A, 175B, 175C, 175D, 275. For example, while a comparatively expensive choice, a silicon wafer also could be utilized as a substrate 100, 200. In other exemplary embodiments, however, a plastic-coated paper product is utilized to form the substrate 100, such as the patent stock and 100 lb. cover stock available from Sappi, Ltd., or similar coated papers from other paper manufacturers such as Mitsubishi Paper Mills, Mead, and other paper products. In additional exemplary embodiments, any type of substrate 100, 200 may be utilized, with additional sealing or encapsulating layers (such as lacquer and vinyl) applied to a surface of the substrate 100, 200, as disclosed in the related applications cited above.

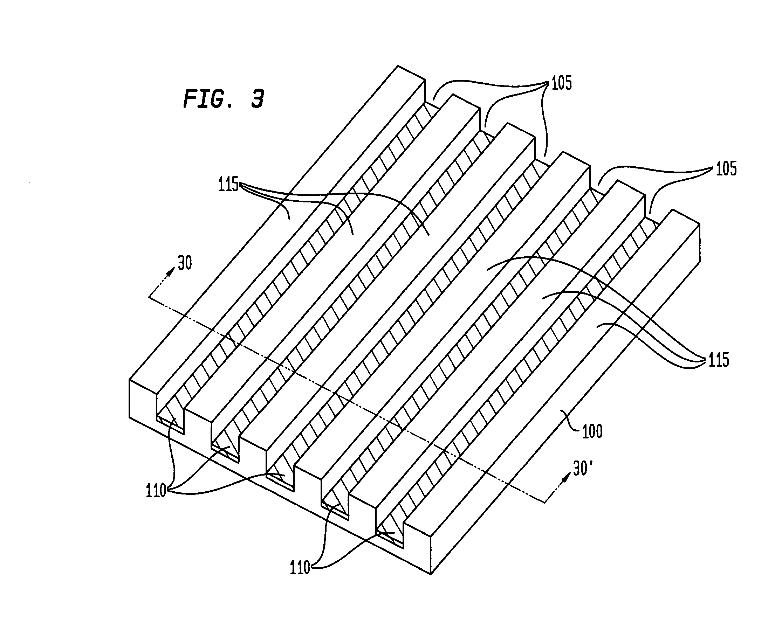

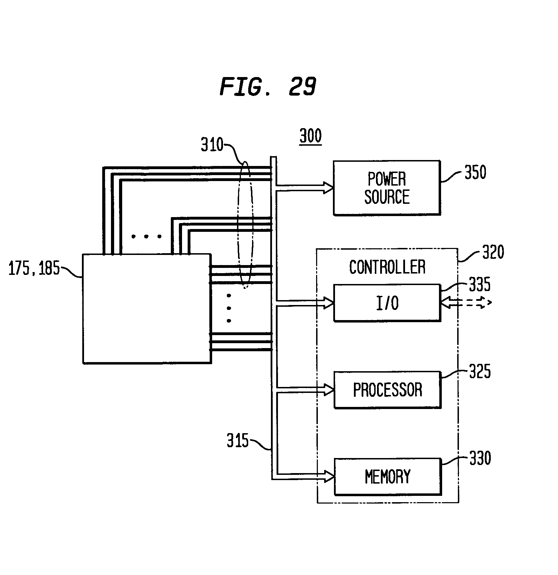

In accordance with the present invention, a plurality of first conductors 110 are then applied or deposited within the corresponding plurality of cavities 1 O5, 205. As discussed in greater detail below, for the plurality of cavities 205, the plurality of first conductors 110 can be deposited in either one step or in two steps, illustrated as plurality of first conductors 110A and 110B. Figure 3 is a perspective view of a first exemplary substrate 100 with a plurality of first conductors 110 having been deposited for an apparatus embodiment 175, 185 in accordance with the teachings of the present invention. Figure 4 is a cross-sectional view (through the 30-30' plane) of the first exemplary substrate 100 with a plurality of first conductors 110 for an apparatus 175, 185 embodiment in accordance with the teachings of the present invention. In an exemplary method of manufacturing the exemplary apparatuses 175, 185, 275, a conductive ink (such as a silver (Ag) ink) is printed or otherwise applied to the substrate 100 (or 200), and subsequently cured or partially cured (such as through an ultraviolet (*uv*) curing process), to form the plurality of first conductors 110 (and also may be utilized to form the plurality of third conductors 145, and also the bus 310, 315 of Figure 29 and any electrical or other conductive terminations discussed below).

Other conductive inks or materials may also be utilized to form the first conductors 110, third conductors 145, and any other non-transmissive conductors such as bus 310, 315, such as copper, tin, aluminum, gold, noble metals or carbon inks, gels or other liquid or semi-solid materials. In addition, any other printable or coatable conductive substances may be utilized equivalently to form the first conductors 110, third conductors 145 and/or bus 310, 315, and exemplary conductive compounds include: (1) From Conductive Compounds (Londonberry, NH, USA), AG-500, AG-800 and AG-510 Silver conductive inks, which may also include an additional coating UV-1006S ultraviolet curable dielectric (such as part of a first dielectric layer 125); (2) From DuPont, 7102 Carbon Conductor (if overprinting 5000 Ag), 7105 Carbon Conductor, 5000 Silver Conductor (also for bus 310, 315 of Figure 29 and any terminations), 7144 Carbon Conductor (with UV Encapsulants), 7152 Carbon Conductor (with 7165 Encapsulant), and 9145 Silver Conductor (also for bus 310, 315 of Figure 29 and any terminations); (3) From SunPoly, Inc., 128A Silver conductive ink, 129A Silver and Carbon Conductive Ink, 140A Conductive Ink, and 150A Silver Conductive Ink; and (4) From Dow Coming, Inc., PI-2000 Series Highly Conductive Silver Ink. As discussed below, these compounds may also be utilized to form third conductors 145, bus 310, 315, and any other conductive traces or connections. In addition, conductive inks and compounds may be available from a wide variety of other sources.

Conductive polymers may also be utilized to form the plurality of first conductors 110, third conductors 145 and/or bus 310, 315. For example, polyethylene-dioxithiophene may be utilized, such as the polyethylene-dioxithiophene commercially available under the trade name "Orgacon" from Agfa Corp. of Ridgefield Park, New Jersey, USA. Other conductive polymers, without limitation, which may be utilized equivalently include polyaniline and polypyrrole polymers, for example.

In an exemplary embodiment, an embossed substrate 100 is utilized, such that the substrate 100 has an alternating series of ridges forming (generally smooth) peaks and valleys, generally all having a substantially parallel orientation, respectively illustrated as raised (or non-channel) portions 115 and cavities (e.g., channels) 105. Conductive inks or polymers may then be applied to remain in either the embossed peaks or valleys, and preferably not to remain in both the peaks and valleys for addressable displays, creating a plurality of first conductors 110 which are not only substantially parallel, but which also have a physical separation from each other determined by the embossing. Indeed, when the conductive inks or polymers are applied to the embossed valleys, the corresponding first plurality of conductors 110 are also separated from each other by the embossed peaks, creating a physical and insulated separation in addition to being spaced apart. For example, conductive inks or polymers may be applied to an embossed substrate in its entirety, and then utilizing a "doctor blade", the conductive inks or polymers are removed from all of the peaks, such as by scraping the blade across the surface of the substrate 100, 200 having a coating of a conductive ink, leaving the conductive inks or polymers to form a first plurality of conductors 110 having a substantially parallel orientation. Alternatively, conductive inks or polymers may be applied (using negligible or zero pressure) to the embossed peaks only, such as by tip printing, also leaving the conductive inks or polymers to form a first plurality of conductors having a substantially parallel orientation.

For example, a conductive ink may be coated or otherwise applied in excess over the entire or most of the substrate 100, 200 with the excess conductive ink subsequently removed using a "doctor blade" or other type of scraping as known in the printing arts, followed by *uv* curing of the conductive ink within the plurality of channels 105. Using such a doctor blade, the conductive ink within the plurality of cavities 105, 205 is allowed to remain in place, with the balance of the conductive ink (such as covering the non-channel portions of the substrate (raised portions 115) being removed by the scraping process, such as due to contact from the doctor blade. Depending upon the type of printing, including the stiffness of the doctor blade and the applied pressure, the conductive ink may form a meniscus within each of the plurality of cavities 105, 205 or may bow upward instead, for example. Those having skill in the electronic or printing arts will recognize innumerable variations in the ways in which the plurality of first conductors 110 may be formed, with all such variations considered equivalent and within the scope of the present invention.

As a consequence, as used herein, "printing" means, refers to and includes any and all printing, coating, rolling, spraying, layering, sputtering, deposition, lamination and/or affixing processes, whether impact or non-impact, currently known or developed in the future, including without limitation screen printing, inkjet printing, electro-optical printing, electroink printing, photoresist and other resist printing, thermal printing, laser jet printing, magnetic printing, pad printing, flexographic printing, hybrid offset lithography, Gravure and other intaglio printing. All such processes are considered printing processes herein, may be utilized equivalently, and are within the scope of the present invention. Also significant, the exemplary printing processes do not require significant manufacturing controls or restrictions. No specific temperatures or pressures are required. No clean room or filtered air is required beyond the standards of known printing processes. For consistency, however, such as for proper alignment (registration) of the various successively applied layers forming the various embodiments, relatively constant temperature (with a possible exception, discussed below) and humidity may be desirable. In addition, the various compounds utilized may be contained within various polymers, binders or other dispersion agents which may be heat-cured or dried, air dried under ambient conditions, or *uv* cured, for example, and all such variations are within the scope of the present invention.

A particular advantage of use of a substrate 100, 200 having a plurality of cavities 105, 205 is that printing registration is not required to be exact, and a one-dimensional or relative registration may be sufficient for the successive applications of the different materials and layers forming the apparatus 175, 185, 275.

It should be noted that depending upon the selected embodiment, the substrate 100, 200 may have a substantially flat, smooth or even surface, without a plurality of cavities 105, 205. For example, when a static display apparatus 275 is formed, a substrate 100, 200 may be utilized which has a substantially flat, smooth or even surface, and one or more first conductors 110 may also be deposited as one electrode or as one or more separate electrodes (which also may be substantially flat), as a capability or adaptability for separate addressing of a plurality of first conductors 110 would not be required. As discussed in greater detail below, the resulting apparatus is highly useful for applications such as lighting or static displays. Such an apparatus 275 embodiment is illustrated in Figure 19, with corresponding cross-sections illustrated in Figures 27 and 28.

Following deposition of the plurality of first conductors 110, the material (such as a conductive ink or polymer) may be cured or partially cured, to form a solid or semi-solid. In other embodiments, the plurality of first conductors 110 may remain in a liquid form and cured subsequently. Following the deposition of the plurality of first conductors 110, with any such curing, partial curing, or non-curing, a suspension of a plurality of electronic components 120 (*e.g*., diodes 120A, such as light-emitting diodes or photovoltaic diodes, or transistors 120B) in an insulating binder 135 is applied over the plurality of first conductors 110, and the plurality of electronic components 120 are then oriented using an applied field 150, such as an electrical or magnetic field, for example. In an exemplary embodiment, a sonic field is also applied at least partially concurrently with the application of a substantially uniform electrical field. The sonic field is utilized to provide some mechanical vibration to the plurality of electronic components 120, to reduce potentially any inertia of the plurality of electronic components 120 and possibly aid in their orientation by the applied electrical or magnetic field; in other embodiments, other means or forms of vibration or inertial reduction may be utilized equivalently.

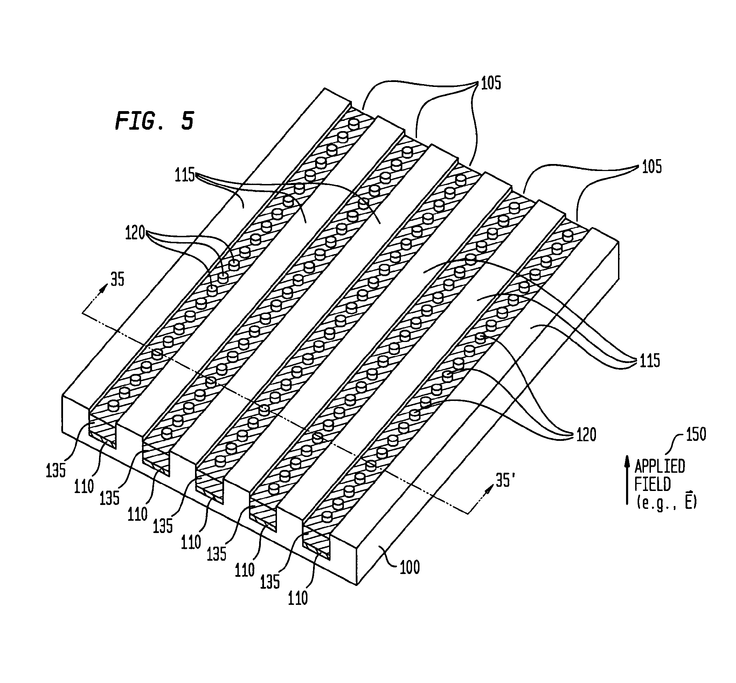

The suspension of a plurality of electronic components 120 in an insulating binder 135 may be applied, for example, through a printing or coating process, such as by printing within the plurality of cavities 105, 205 having the plurality of first conductors 110. Also for example, the suspension of a plurality of electronic components 120 in an insulating binder 135 may be coated over the substrate and plurality of first conductors 110, with any excess removed using a doctor blade or other scraping process. In an exemplary apparatus 175, 185, 275 embodiment, the plurality of electronic components 120 are oriented (via an applied field 150) to be substantially perpendicular to the plane of the substrate 100, 200. Figure 5 is a perspective view and Figure 6 is a cross-sectional view (through the 35-35' plane) of a first exemplary substrate 100 with a plurality of first conductors 110 and a plurality of electronic components 120 having been deposited in an insulating binder 135 and oriented in an applied field 150 for an apparatus 175, 185, 275 embodiment in accordance with the teachings of the present invention.

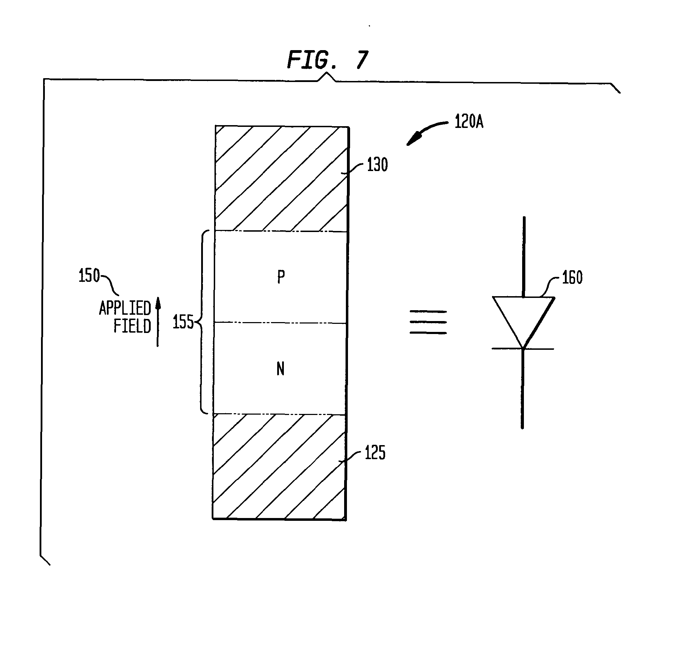

Figure 7 is a simplified cross-sectional view with an electronic equivalent circuit element 160 of an exemplary electronic component 120, illustrated as a diode 120A, oriented in an applied field 1 SO for an apparatus 175, 185 embodiment in accordance with the teachings of the present invention. As illustrated, the diode 120A comprises a pn junction 155 which, due to its dopant composition, has an intrinsic voltage and corresponding electromagnetic field. Also as illustrated, the diode 120 further comprises first and second conductors 125 and 130, respectively, which may be formed during fabrication as part of or integrated with the exemplary electronic component 120. The present invention advantageously exploits effects due to the intrinsic voltage, in which a suspended diode 120A or other exemplary electronic component 120 has such an intrinsic voltage and may exhibit a dipole effect. More specifically, when freely suspended and allowed to move (such as within the insulating binder 135), such a dipole will move or rotate in response to an applied electromagnetic field (150), to become parallel (or antiparallel, depending on the polarity) with the applied field 150.

Other types of applied fields 150 may also be utilized, in addition to static or dynamic magnetic, and/or electromagnetic fields. For example, a sonic field may be utilized to orient certain types of electronic components or particles and bond them to the plurality of first conductors. Other types of radiation, such as uv radiation, or laser light (such as used to provide laser tweezers), may also be used as the applied field 150. Temperature curing and/or bonding may also be utilized, depending on the selected embodiment and the selected electronic components. The strength of the applied field 150 may also be varied, for example, to provide sufficient force to create a sufficient electrical contact between the electronic components and the plurality of first conductors. Also, the orientation of the applied field may be varied, such as to be perpendicular to the channels 105 but parallel to the plane of the substrate 100, for example, depending upon the type of electronic components which are being oriented. The ability of the electronic components such as diodes 120A (*e.g*., LEDs or photovoltaic diodes) to be oriented in a field, such as an electrical field, may also be utilized to differentiate working diodes 120A (*e.g*., LEDs or photovoltaic diodes) from non-working diodes 120A (*e.g*., LEDs or photovoltaic diodes) (which may be defective and not exhibit the dipole effect discussed above).

In addition, in exemplary embodiment, electronic components such as diodes 120A may be differentially deposited, such as printing a first row/cavity of red LEDs 120A, a second first row/cavity of green LEDs 120A, a third first row/cavity of blue LEDs 120A, a fourth first row/cavity of red LEDs 120A, etc., creating a color dynamic display, as discussed below, with each such LED 120A capable of emitting light of the corresponding color (wavelength), and with each such LED 120A defining a pixel or sub-pixel.

The insulating binder 135 may also include reflective, diffusing or scattering particles, for example, to aid in light transmission in a direction normal to the substrate 100.

Accordingly, referring to Figures 5, 6 and 7, when the plurality of electronic components 120 (*e.g.,* diodes 120A (*e.g.,* LEDs or photovoltaic diodes) or transistors 120B) in an insulating binder 135 is applied over the plurality of first conductors 110, and the plurality of electronic components 120 are then oriented using an applied field 150 (such as an electrical or magnetic field) as illustrated (with the applied field perpendicular to the plane of the substrate 100), the plurality of electronic components 120 also become oriented in a direction perpendicular to the plane of the substrate 100. Once the plurality of electronic components 120 are aligned or oriented, the insulating binder 135 is then cured, holding the oriented plurality of electronic components 120 in place. With such orientation, the plurality of electronic components 120 make corresponding electrical contacts with the plurality of first conductors 110; the first and second conductors 125 and 130 formed as part of the plurality of electronic components 120 may also facilitate the creation of such electrical contacts with the plurality of first conductors 110. In addition, the creation of such electrical contacts may be further facilitated when the plurality of first conductors 110 have not yet been cured or have only been partially cured, such that the aligned, oriented plurality of electronic components 120 become embedded within the plurality of first conductors 110, followed by curing both the insulating binder 135 and plurality of first conductors 110 with the aligned, oriented plurality of electronic components 120 in place.

In exemplary embodiments, the field 150 may be applied in any of various manners; for example, the applied field may be pulsed initially, such as to help align the plurality of electronic components 120 in the same orientiation (*e.g*., p side adjacent to the plurality of first conductors 110 or n-side adjacent to the plurality of first conductors 110), followed by maintaining the applied field 150 in a comparatively constant manner to stabilize the plurality of electronic components 120 while the insulating binder 135 is cured or otherwise solidified. In an exemplary embodiment, the field 150 is applied substantially uniformly and is substantially constant while the insulating binder 135 is uv cured. A sonic field may also be applied initially with an electric field, followed by discontinuing the sonic field and continuing to apply the electric field 150 substantially uniformly and constantly while the insulating binder 135 is *uv* cured. In an other example, not forming part of the present invention, a DC electric field 150 is applied substantially uniformly and is substantially constant while the insulating binder 135 is non-*uv* cured, using other wavelengths of electromagnetic radiation, such as within the visible spectrum. In an other example, not forming part of the present invention, a DC electric field 150 is applied substantially uniformly and is substantially constant while (1) the insulating binder 135 is non-uv cured, using other wavelengths of electromagnetic radiation, such as within the visible spectrum, followed by (2) *uv* curing, or vice-versa. In an other example, not forming part of the present invention, a substantially constant DC electric field 150 is applied substantially uniformly and it provides the curing of the insulating binder 135. In an other example, not forming part of the present invention, a substantially constant DC electric field 150 is applied substantially uniformly and it provides the curing of the insulating binder 135, followed by additional curing from an AC electromagnetic field, which may be *uv* or non-uv wavelengths. Also in an exemplary embodiments, upper and lower electrodes (not separately illustrated) having various shapes may be utilized to create the substantially uniform electric field, such as having the shape of a flat sheet or grate.

The insulating (or dielectric) binder 135, and any second insulating (or dielectric) binder 170, may be comprised of any curable compounded having a reasonably high dielectric constant sufficient to provide electrical insulation between the plurality of first conductors 110 and the plurality of second conductors 140 discussed below. A wide variety of dielectric compounds may be utilized, and all are within the scope of the present invention, and may be included within heat- or *uv-*curable binders, for example, to form the insulating binder 135, 170. Exemplary dielectric compounds utilized to form the insulating (or dielectric) binder 135 include, without limitation: (1) From Conductive Compounds, a barium titanate dielectric; (2) From DuPont, 5018A Clear UV Cure Ink, 5018G Green UV Cure Ink, 5018 Blue UV Cure Ink, 7153 High K Dielectric Insulator, and 8153 High K Dielectric Insulator; (3) From SunPoly, Inc., 305D UV Curable dielectric ink and 308D UV Curable dielectric ink; and (4) from various suppliers, Titanium Dioxide-filled UV curable inks.

Those having skill in the art will also recognize that various removable or etchable compounds may also be utilized. For example, once the plurality of electronic components 120 have been embedded within or make sufficient electrical contact with the plurality of first conductors 110, have been properly oriented, followed by curing, all or part of the insulating binder 135 may be removed, such as through an acid or ion etching process. Such an etching or washing process may also facilitate providing additional electrical contacts with the plurality of electronic components 120, such as the subsequent formation of electrical contacts with the plurality of second conductors 140 at the corresponding second ends of the plurality of electronic components 120. Following such an etching or washing process, another or additional dielectric binders also may be applied and allowed to cure, depending upon the selected embodiment.

In another variation, not forming part of the present invention, the electronic components 120 are suspended in a solvent (instead of the binder 135) and oriented using the applied field. The solvent is then allowed to evaporate, such as through the application of heat, and while the electronic components are still properly oriented, they are bonded to the plurality of first conductors, such as through annealing or other application of heat.

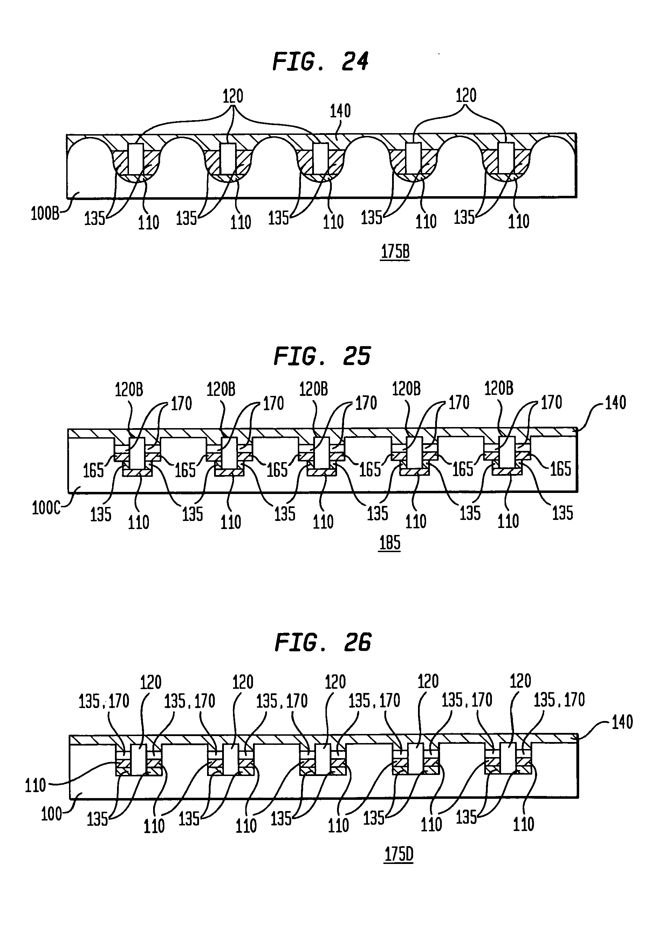

As discussed below with reference to Figure 26, the ordering between the deposition of the plurality of first conductors and the deposition of the plurality of electronic components in an insulating binder may also be reversed.

Figures 8-16 serve to illustrate an additional apparatus embodiment 175C, using cavities 205 (in a substrate 200), which are shaped differently than the cavities 105, and are discussed herein only to the extent that the different shape may require additional or different steps to form the apparatus 175C.

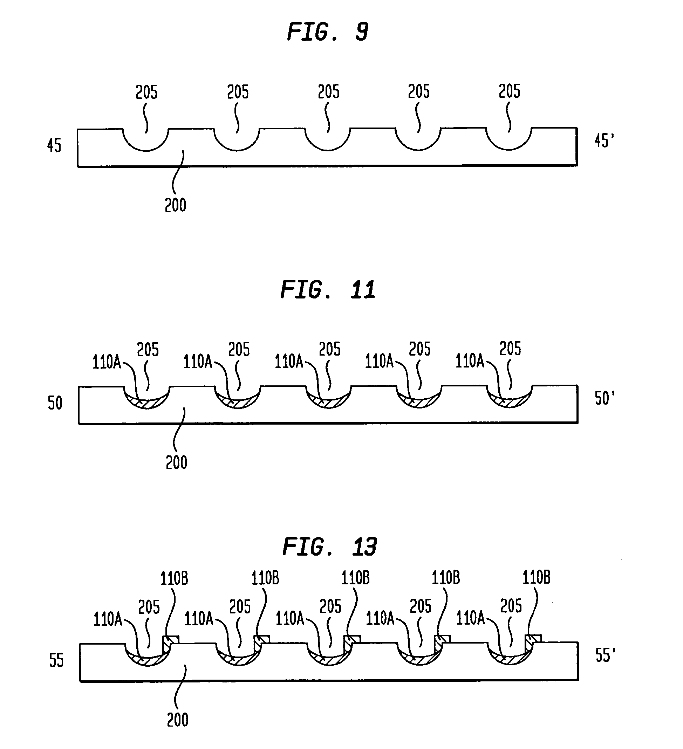

Figure 8 is a perspective view of a second exemplary substrate 200 for an apparatus embodiment in accordance with the teachings of the present invention. Figure 9 is a cross-sectional view (through the 45-45' plane) of the second exemplary substrate 200 for an apparatus embodiment in accordance with the teachings of the present invention. As illustrated, the substrate 200 differs from the substrate 100 only insofar as the plurality of cavities 105, 205 are shaped differently. The substrate 200 has substantially circular or hemi-spherical shaped depressions, dimples or bores, illustrated as cavities 205, rather than elongated channels or grooves. For example, the cavities 205 may be partially spherically-shaped (*e.g*., a quarter or an eighth of a sphere) and arranged in a Cartesian array.

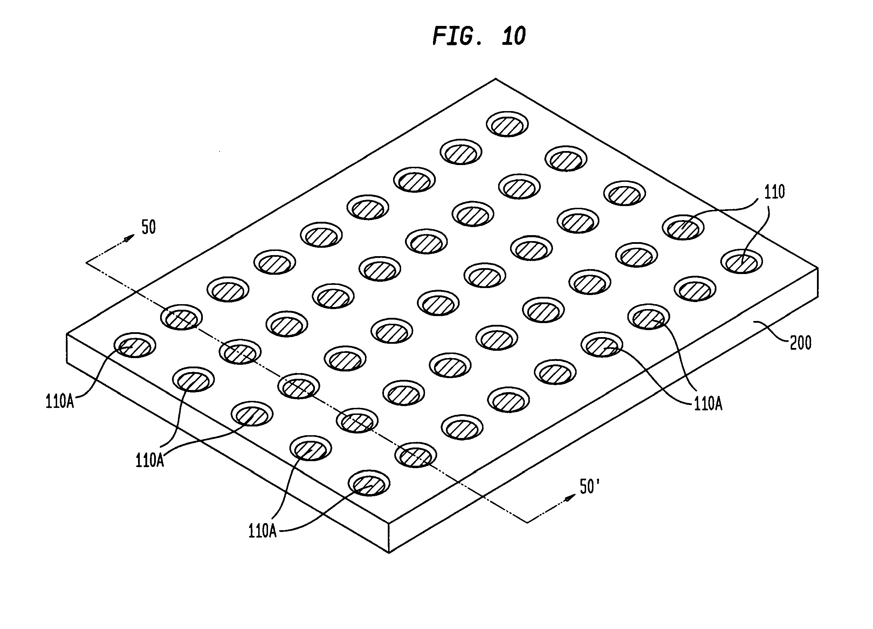

Figure 10 is a perspective view of a second exemplary substrate 200 with a plurality of first conductors 110A having been deposited for an apparatus embodiment in accordance with the teachings of the present invention. Figure 11 is a cross-sectional view (through the 50-50' plane) of the second exemplary substrate 200 with a plurality of first conductors 110A for an apparatus embodiment in accordance with the teachings of the present invention. As discussed above, the plurality of first conductors 110A may be formed identically to the plurality of first conductors 110, using identical or similar compounds and methods. Rather than forming a series of "wires" however, each of the plurality of first conductors 110A forms an individual conductive "dot" or substantially-circularly shaped conductor.

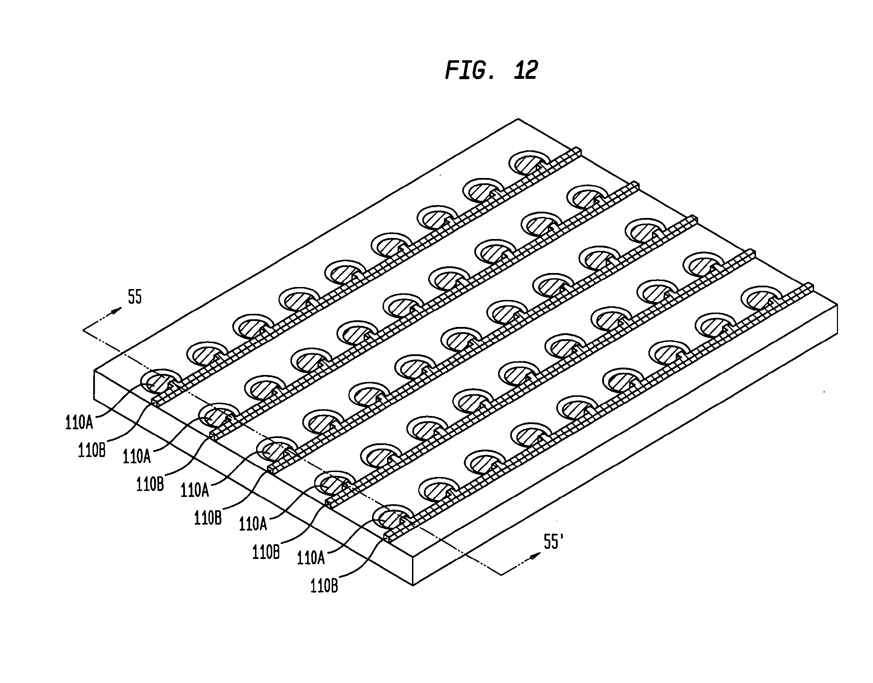

Figure 12 is a perspective view of a second exemplary substrate 200 with a plurality of first conductors 110A and 110B having been deposited for an apparatus embodiment in accordance with the teachings of the present invention. Figure 13 is a cross-sectional view (through the 55-55' plane) of the second exemplary substrate 200 with a plurality of first conductors 110A and 110B having been deposited for an apparatus embodiment in accordance with the teachings of the present invention. As mentioned above, Figures 10-13 illustrate the deposition of the plurality of first conductors 110 in two steps, as the plurality of first conductors 110A and 110B. The plurality of first conductors 110B are deposited to make electrical contact with the plurality of first conductors 110A, *e.g*., forming or providing leads to the plurality of first conductors 110A, and are shaped to form elongated or "wire" shaped conductors, to provide access to the plurality of first conductors 110A to and from the more peripheral sections of the substrate 200. The plurality of first conductors 110B then allow electrical conduction to the plurality of first conductors 110A, and subsequently to electronic components 120.

Alternatively, the plurality of first conductors 110 may be deposited in one step in this embodiment. For example, the plurality of first conductors 110 may be printed using a conductive ink, as illustrated for plurality of first conductors 110B, with a portion allowed to flow or drip into the cavities 205 to form the plurality of first conductors 110A.

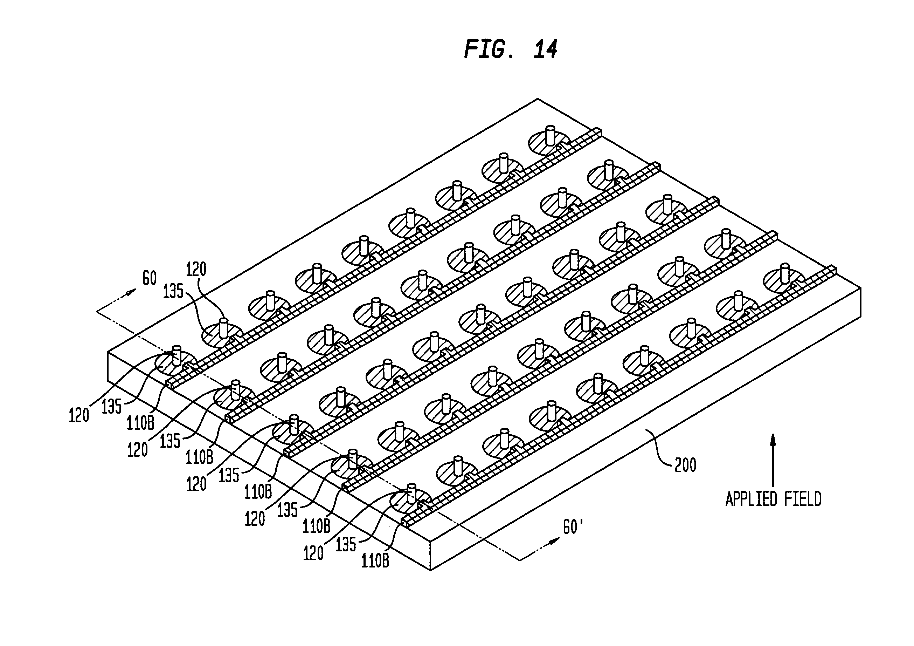

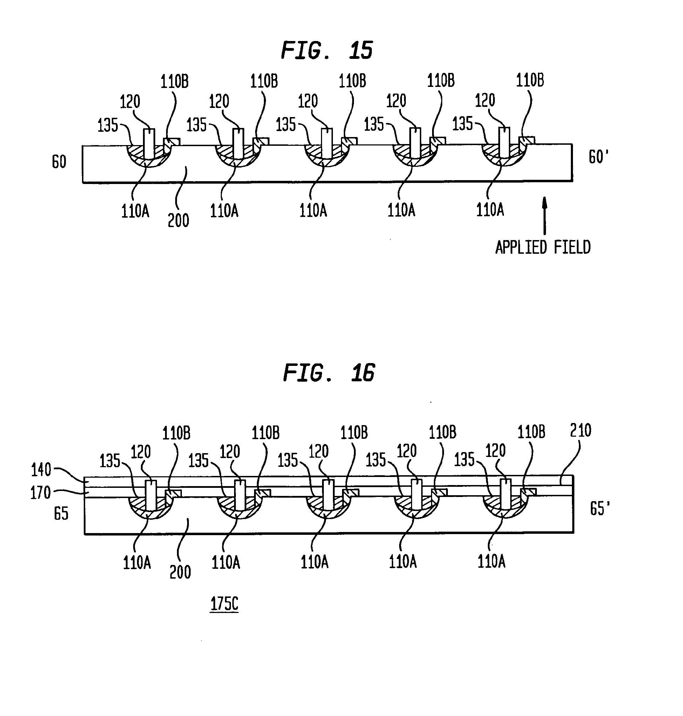

Figure 14 is a perspective view of a second exemplary substrate 200 with a plurality of first conductors 110A and 110B and a plurality of electronic components 120 having been deposited for an apparatus embodiment in accordance with the teachings of the present invention. Figure 15 is a cross-sectional view (through the 60-60' plane) of the second exemplary substrate 200 with a plurality of first conductors 110A and 110B and a plurality of electronic components 120 having been deposited for an apparatus embodiment in accordance with the teachings of the present invention. The plurality of electronic components 120 may be deposited, oriented and cured in an insulating (or dielectric) binder 135 as previously discussed.

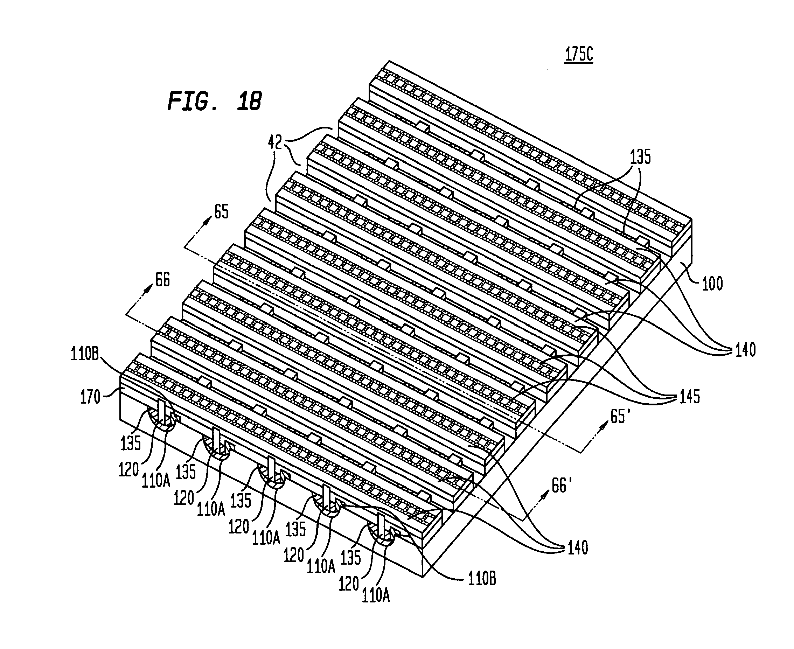

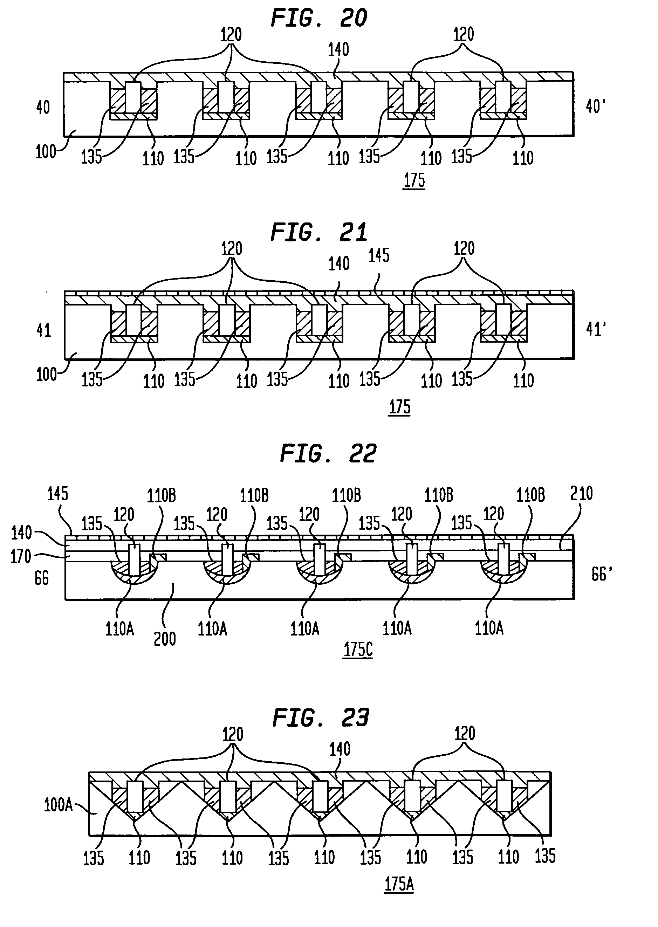

Figure 18 is a perspective view of a second exemplary apparatus embodiment in accordance with the teachings of the present invention. Figure 16 is a first cross-sectional view (through the 65-65' plane) and Figure 22 is a second cross-sectional view (through the 66-66' plane) of a second exemplary apparatus embodiment in accordance with the teachings of the present invention., and are similar to the cross-sectional views of Figures 20 and 21, discussed below. It should be noted, however, that because the plurality of first conductors 110B are exposed in Figures 14 and 15, rather than confined within a channel-shaped cavity 105, a second insulating layer 170 has been applied over the plurality of first conductors 110B, such as through a printing or coating process, prior to deposition of a plurality of second conductors 140 or a single second conductor 140 (*e.g*., a second conductive layer). In addition, the second insulating layer 170 may be comprised of any of the insulating or dielectric compounds previously discussed.

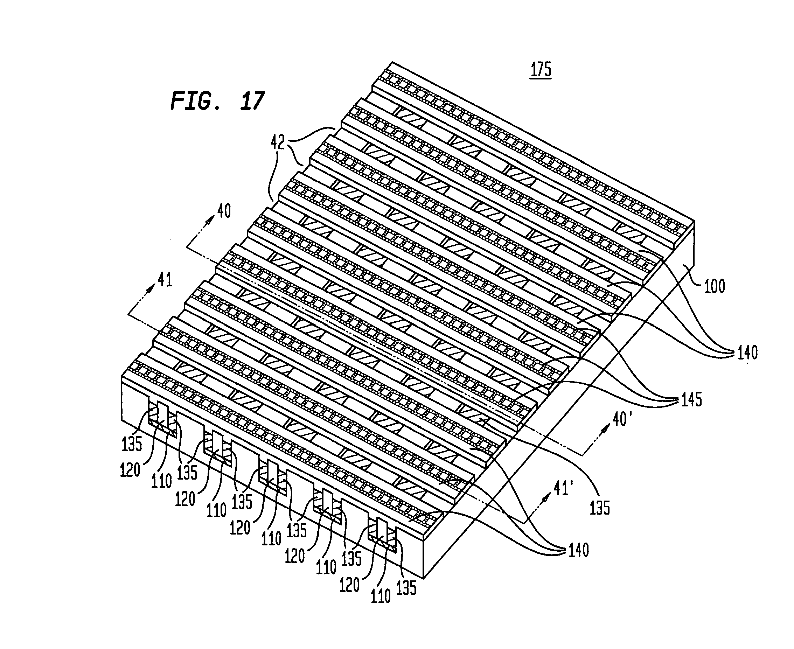

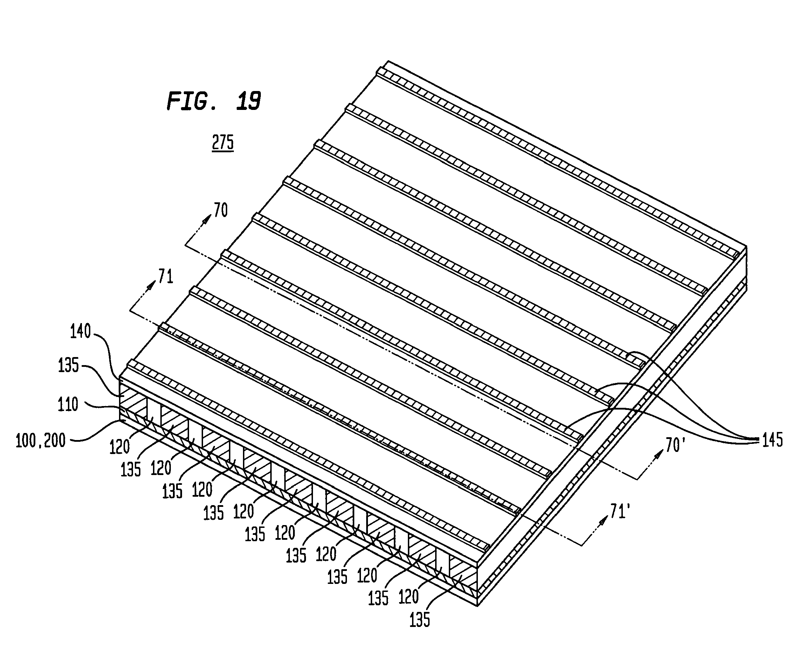

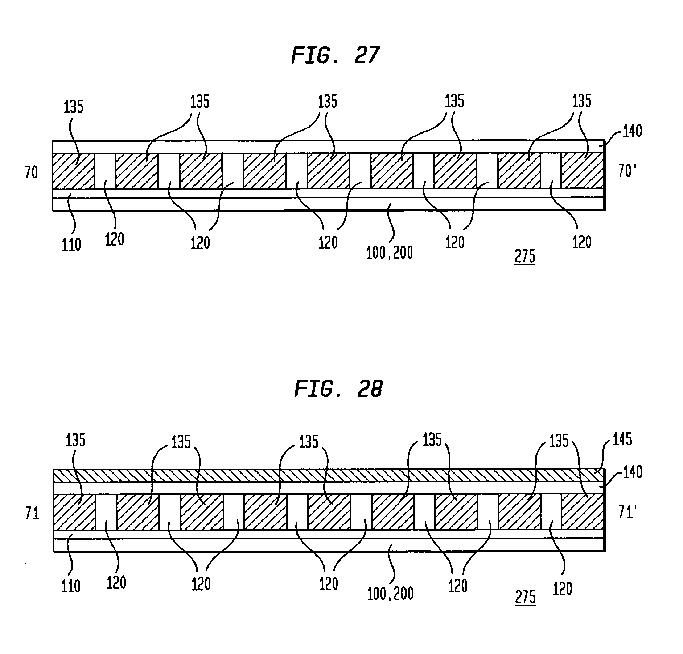

Figure 17 is a perspective view of a first exemplary apparatus embodiment 175 in accordance with the teachings of the present invention. Figure 20 is a first cross-sectional view (through the 40-40' plane) and Figure 21 is a second cross-sectional view (through the 41-41' plane) of the first exemplary apparatus embodiment in accordance with the teachings of the present invention. Figure 19 is a perspective view of a third exemplary apparatus embodiment 275 in accordance with the teachings of the present invention. Figure 27 is a first cross-sectional view (through the 70-70' plane) and Figure 28 is a second cross-sectional view (through the 71-71' plane) of the third exemplary apparatus embodiment in accordance with the teachings of the present invention.

Referring to Figures 16 - 28, following orientation of the plurality of electronic components 120 and curing of the supporting and stabilizing insulating binder 135, and following deposition of an additional insulating layer(s) (*e.g*., 170, discussed above), an optically transmissive (or transparent) second conductor 140 is applied. Such a transmissive second conductor 140 may be applied as a single electrode to form a static or regional display, or for lighting applications, as illustrated in Figure 19, or as a plurality of second conductors 140 (as illustrated in Figures 17 and 18) to form an addressable display. The transmissive second conductor(s) 140 may be comprised of any compound which: (1) has sufficient conductivity to energize selected portions of the apparatus 175, 185, 275 in a predetermined or selected period of time; and (2) has at least a predetermined or selected level of transparency or transmissibility for the selected wavelength(s) of electromagnetic radiation, such as for portions of the visible spectrum. For example, when the present invention is utilized for a static display having a comparatively smaller form factor, the conductivity time or speed in which the transmissive second conductor(s) 140 provides energy across the display to energize the plurality of electronic components 120 is comparatively less significant than for other applications, such as for active displays of time-varying information (*e.g*., computer displays) or for static displays having a comparatively larger form factor. As a consequence, the choice of materials to form the transmissive second conductor(s) 140 may differ, depending on the selected application of the apparatus 175, 185, 275 and depending upon the utilization of optional one or more third conductors 145 (discussed below).

The one or more transmissive second conductor(s) 140 are applied over exposed portions of the plurality of electronic components 120 (held in place by the insulating binder 135), and any additional insulating layer(s), using a printing or coating process as known or may become known in the printing or coating arts, with proper control provided for any selected alignment or registration. For example, in the various exemplary embodiments discussed below, a plurality of transmissive second conductors 140 is utilized to create multiple, electrically isolated electrodes (individual transparent wires), which may be formed during one or more printing cycles, and which should be properly aligned in comparison with the plurality of first conductors 110, to provide for proper pixel selection using corresponding pixel addressing, as may be necessary or desirable for a selected application. A selected pixel is then formed by the region of overlap between a selected first conductor 110 and a selected second conductor 140, which when energized, provide power to the corresponding electronic component 120 contained therein, such as to cause light emission from a diode 120A. In other applications, such as for static displays or signage, in which the transmissive second conductor 140 may be a unitary sheet as illustrated in Figure 19, for example, such alignment issues are comparatively less significant.

In the exemplary embodiment of apparatus 175, 185, 275, polyethylene-dioxithiophene (*e.g*., Orgacon), a polyaniline or polypyrrole polymer, indium tin oxide (ITO) and/or antimony tin oxide (ATO) is utilized to form the transmissive second conductor(s) 140. While ITO or ATO provides sufficient transparency for visible light, its impedance or resistance is comparatively high (*e.g*., 20 k Ω), generating a correspondingly comparatively high (*i.e.,* slow) time constant for electrical transmission across this layer of the apparatus 175, 185, 275, such as down a corresponding electrode. Other compounds having comparatively less impedance may also be utilized, such as polyethylene-dioxithiophene. As a consequence, in some of the exemplary embodiments, one or more third conductors 145 having a comparatively lower impedance or resistance is or may be incorporated into corresponding transmissive second conductor(s) 140, to reduce the overall impedance or resistance of this layer, decrease conduction time, and also increase the responsiveness of the apparatus 175, 185, 275 to changing information for dynamic displays. As indicated above, for static displays having larger form factors, such one or more third conductors 145 may be utilized to provide more rapid illumination, enabling the energizing of the more central portions of the area to be illuminated, which would otherwise remain non-energized and dark, due to the insufficient conduction of many types of compounds which may be selected for use in the transmissive second conductor(s) 140. This is also significant for illumination in various patterns for larger displays, such as for rapid blinking or sequential illumination of different display regions. For example, to form one or more third conductors 145, one or more fine wires may be formed using a conductive ink or polymer (*e.g*., a silver ink or a polyethylene-dioxithiophene polymer) printed over corresponding strips or wires of the transmissive second conductor(s) 140, or one or more fine wires (*e.g*., having a grid pattern) may be formed using a conductive ink or polymer printed over a larger, unitary transparent second conductor 140 in larger displays, to provide for increased conduction speed throughout the transparent second conductor 140.

In an exemplary addressable display embodiment, the one or more third conductors 145 are formed as a series of fine wires using a conductive ink, with one or two wires disposed centrally in the longitudinal axis of each second conductor of the plurality of second conductors 140, and having a width comparable to the separation between each of the second conductors of the plurality of second conductors 140. In this embodiment, an illuminated region may have a visual appearance of two illuminated pixels, depending upon the selected resolution. In another exemplary embodiment, each of the one or more third conductors 145 may have a "ladder" shape, with two longitudinal wires being connected to each other by perpendicular wires.

Other compounds which may be utilized equivalently to form the transmissive second conductor(s) 140 include indium tin oxide (ITO) as mentioned above, and other transmissive conductors as are currently known or may become known in the art, including one or more of the conductive polymers discussed above, such as polyethylene-dioxithiophene available under the trade name "Orgacon". Representative transmissive conductive materials are available, for example, from DuPont, such as 7162 and 7164 ATO translucent conductor. The transmissive second conductor(s) 140 may also be combined with various binders, such as binders which are curable under various conditions, such as exposure to ultraviolet radiation (uv curable).

Referring again to Figure 19, as mentioned above, the first conductive medium may be deposited to form a first conductor 110, rather than a plurality of first conductors 110. For example, the first conductor 110 may be printed as a larger, flat electrode over the substrate 100, 200. Similarly, the second conductive medium may be deposited to form a second conductor 140, rather than a plurality of first conductors 140. As an option, one or more third conductors 145 may also be included in this exemplary embodiment. When the first and second conductors are then energized, resulting in the provision of power to the plurality of electronic components such as diodes 120A, the diodes 120A emit light in the visible spectrum. The resulting apparatus 275, therefore, has particular usefulness for lighting applications and for static display applications.

Figure 27 is a first cross-sectional view (through the 70-70' plane) of the third exemplary apparatus embodiment in accordance with the teachings of the present invention. Figure 28 is a second cross-sectional view (through the 71-71' plane) of the third exemplary apparatus embodiment in accordance with the teachings of the present invention. As indicated above, the third apparatus utilizes a single first conductor 110 and a single second conductor 140, and optionally may also include one or more third conductors 145 over or within the second conductor 140.

Not separately illustrated in Figures 16 - 28, following deposition of the transmissive second conductor(s) 140 and the optional one or more third conductors 145, various protective coatings may be applied, as indicated in the related applications incorporated herein by reference. For example, the various spaces 42 between the second conductors 140 may be filled in by any of various optically transmissive or opaque materials. In addition, various colors (such as red, green and blue ("RGB")) may be overprinted, defining colored pixels over each of the plurality of electronic components 120. In another alternative, such as when light-emitting diodes are the type of diodes 120A utilized, the various LEDs 120A may be selected to provide corresponding colors, such as corresponding RGB colors, and printed and aligned to form corresponding pixels.

When one or more of the plurality of first conductors 110 and one or more of the plurality of transmissive second conductor(s) 140 (and the optional one or more third conductors 145) are energized, such as through the application of a corresponding voltage, energy will be supplied to each of the electronic components 120 (*e.g.,* diodes 120A (*e.g*., LEDs)) at the corresponding intersections (overlapping areas) of the energized first conductors 110 and second conductor(s) 140, defining a pixel, for example. Accordingly, by selectively energizing the first conductors 110 and second conductor(s) 140, the apparatus 175, 185 provides a pixel-addressable, dynamic display. For example, the plurality of first conductors 110 may comprise a corresponding plurality of rows, with the plurality of transmissive second conductor(s) 140 (and the optional one or more third conductors 145) comprising a corresponding plurality of columns, with each pixel defined by the intersection or overlapping of a corresponding row and corresponding column. When a second conductor 140 is formed as a unitary sheet, also for example and as illustrated in Figure 19, energizing of the conductors 110, 140 will provide power to substantially all (or most) of the plurality of electronic components 120, such as to provide light emission for a static display.

In another exemplary embodiment, when photovoltaic diodes are utilized as the electronic components 120, when the device is exposed to a light source, energy will be generated by the electronic components 120. Electrical energy generated, such as in the form of a voltage or electrical current, may be obtained between the first conductors 110 and the second conductor(s) 140, and utilized as a power source. For such power generating embodiments, additional coatings over the second conductor(s) 140 may be utilized to concentrate or focus light onto the photovoltaic diodes 120A, such as by having or creating a lens effect. In addition, various masking layers may also be utilized, such as over the raised (or non-channel) portions 115.

Figure 23 is a cross-sectional view of a fourth exemplary apparatus embodiment 175A in accordance with the teachings of the present invention. Figure 24 is a cross-sectional view of a fifth exemplary apparatus embodiment 175B in accordance with the teachings of the present invention. Figures 23 and 24 illustrate apparatuses with substrates 100A and 100B, respectively, having different shapes or forms of cavities 105 and ridges/peaks 115, such as triangular or curvilinear channels or grooves, for example.

Figure 25 is a cross-sectional view of an exemplary apparatus 185 not forming part of the present invention. The apparatus 185 differs from the apparatus 175 insofar as the corresponding electronic components 120B are three-terminal components, such as transistors (BJTs or FETs), rather than two-terminal components (such as LEDs 120A). For such an exemplary embodiment, additional conductors are utilized, such as fourth conductors 165, with an additional insulating layer 170, as illustrated. These additional, respective conducting and insulating elements also may be formed through the printing and coating processes discussed above, as additional steps.

Figure 26 is a cross-sectional view of a seventh exemplary apparatus embodiment 175D in accordance with the teachings of the present invention. As previously discussed, the ordering between the deposition of the plurality of first conductors 110 and the deposition of the plurality of electronic components 120 in an insulating binder 135 may also be reversed. As illustrated in Figure 26, the plurality of electronic components 120 in an insulating binder 135 may be deposited into the channels 105 first, then oriented and cured as discussed above. Then, the plurality of first conductors 110 may be formed, such as by printing and curing a conductive ink about or around the electronic components.

Figure 29 is a block diagram illustrating a system embodiment 300 in accordance with the teachings of the present invention. The system 300 includes an apparatus 175, 185 (such as an addressable display), with the various pluralities of first conductors 110 and the plurality of transmissive second conductor(s) 140 (and the optional one or more third conductors 145) coupled through lines or connectors 310 (which may be in the form of a bus) to control bus 315, for coupling to controller (or, equivalently, control logic block) 320, and for coupling to a power source 350, which may be a DC power source (such as a battery or a photovoltaic cell) or an AC power source (such as household or building power). The controller 320 comprises a processor 325, a memory 330, and an input/output (I/O) interface 335.

A "processor" 325 may be any type of controller or processor, and may be embodied as one or more processors 325, adapted to perform the functionality discussed herein. As the term processor is used herein, a processor 325 may include use of a single integrated circuit ("1C"), or may include use of a plurality of integrated circuits or other components connected, arranged or grouped together, such as controllers, microprocessors, digital signal processors ("DSPs"), parallel processors, multiple core processors, custom ICs, application specif integrated circuits ("ASICs"), field programmable gate arrays ("FPGAs"), adaptive computing ICs, associated memory (such as RAM, DRAM and ROM), and other ICs and components. As a consequence, as used herein, the term processor should be understood to equivalently mean and include a single IC, or arrangement of custom ICs, ASICs, processors, microprocessors, controllers, FPGAs, adaptive computing ICs, or some other grouping of integrated circuits which perform the functions discussed below, with associated memory, such as microprocessor memory or additional RAM, DRAM, SDRAM, SRAM, MRAM, ROM, FLASH, EPROM or E²PROM. A processor (such as processor 325), with its associated memory, may be adapted or configured (via programming, FPGA interconnection, or hard-wiring) to perform the methodology of the invention, such as selective pixel addressing. For example, the methodology may be programmed and stored, in a processor 325 with its associated memory (and/or memory 330) and other equivalent components, as a set of program instructions or other code (or equivalent configuration or other program) for subsequent execution when the processor is operative (*i.e*., powered on and functioning). Equivalently, when the processor 325 may implemented in whole or part as FPGAs, custom ICs and/or ASICs, the FPGAs, custom ICs or ASICs also may be designed, configured and/or hard-wired to implement the methodology of the invention. For example, the processor 325 may be implemented as an arrangement of processors, controllers, microprocessors, DSPs and/or ASICs, collectively referred to as a "controller" or "processor", which are respectively programmed, designed, adapted or configured to implement the methodology of the invention, in conjunction with a memory 330.

A processor (such as processor 325), with its associated memory, may be configured (via programming, FPGA interconnection, or hard-wiring) to control the energizing of (applied voltages to) the various pluralities of first conductors 110 and the plurality of transmissive second conductor(s) 140 (and the optional one or more third conductors 145), for corresponding control over what information is being displayed. For example, static or time-varying display information may be programmed and stored, configured and/or hard-wired, in a processor 325 with its associated memory (and/or memory 330) and other equivalent components, as a set of program instructions (or equivalent configuration or other program) for subsequent execution when the processor 325 is operative.

The memory 330, which may include a data repository (or database), may be embodied in any number of forms, including within any computer or other machine-readable data storage medium, memory device or other storage or communication device for storage or communication of information, currently known or which becomes available in the future, including, but not limited to, a memory integrated circuit ("IC"), or memory portion of an integrated circuit (such as the resident memory within a processor 325), whether volatile or non-volatile, whether removable or non-removable, including without limitation RAM, FLASH, DRAM, SDRAM, SRAM, MRAM, FeRAM, ROM, EPROM or E²PROM, or any other form of memory device, such as a magnetic hard drive, an optical drive, a magnetic disk or tape drive, a hard disk drive, other machine-readable storage or memory media such as a floppy disk, a CDROM, a CD-RW, digital versatile disk (DVD) or other optical memory, or any other type of memory, storage medium, or data storage apparatus or circuit, which is known or which becomes known, depending upon the selected embodiment. In addition, such computer readable media includes any form of communication media which embodies computer readable instructions, data structures, program modules or other data in a data signal or modulated signal, such as an electromagnetic or optical carrier wave or other transport mechanism, including any information delivery media, which may encode data or other information in a signal, wired or wirelessly, including electromagnetic, optical, acoustic, RF or infrared signals, and so on. The memory 330 may be adapted to store various look up tables, parameters, coefficients, other information and data, programs or instructions (of the software of the present invention), and other types of tables such as database tables.

As indicated above, the processor 325 is programmed, using software and data structures of the invention, for example, to perform the methodology of the present invention. As a consequence, the system and method of the present invention may be embodied as software which provides such programming or other instructions, such as a set of instructions and/or metadata embodied within a computer readable medium, discussed above. In addition, metadata may also be utilized to define the various data structures of a look up table or a database. Such software may be in the form of source or object code, by way of example and without limitation. Source code further may be compiled into some form of instructions or object code (including assembly language instructions or configuration information). The software, source code or metadata of the present invention may be embodied as any type of code; such as C, C++, SystemC, LISA, XML, Java, Brew, SQL and its variations, or any other type of programming language which performs the functionality discussed herein, including various hardware definition or hardware modeling languages (*e.g*., Verilog, VHDL, RTL) and resulting database files (*e.g*., GDSII). As a consequence, a "construct", "program construct", "software construct" or "software", as used equivalently herein, means and refers to any programming language, of any kind, with any syntax or signatures, which provides or can be interpreted to provide the associated functionality or methodology specified (when instantiated or loaded into a processor or computer and executed, including the processor 325, for example).

The software, metadata, or other source code of the present invention and any resulting bit file (object code, database, or look up table) may be embodied within any tangible storage medium, such as any of the computer or other machine-readable data storage media, as computer-readable instructions, data structures, program modules or other data, such as discussed above with respect to the memory 330, *e.g*., a floppy disk, a CDROM, a CD-RW, a DVD, a magnetic hard drive, an optical drive, or any other type of data storage apparatus or medium, as mentioned above.

The I/O interface 335 may be implemented as known or may become known in the art, and may include impedance matching capability, voltage translation for a low voltage processor to interface with a higher voltage control bus 315, and various switching mechanisms (*e.g*., transistors) to turn various lines or connectors 310 on or off in response to signaling from the processor 325. In addition, the I/O interface 335 may also be adapted to receive and/or transmit signals externally to the system 300, such as through hard-wiring or RF signaling, for example, to receive information in real-time to control a dynamic display, for example.

In addition to the controller 320 illustrated in Figure 29, those of skill in the art will recognize that there are innumerable equivalent configurations, layouts, kinds and types of control circuitry known in the art, which are within the scope of the present invention.

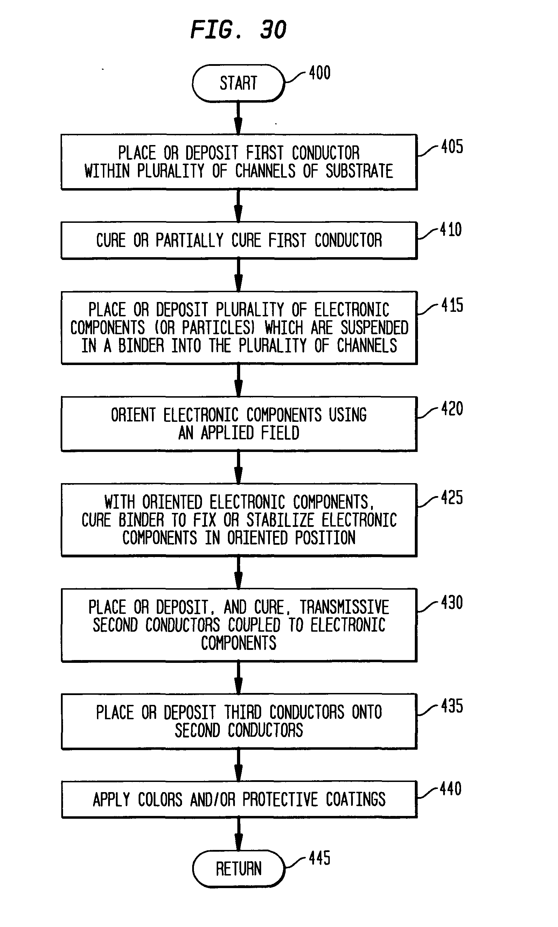

Figure 30 is a flow chart illustrating a method embodiment in accordance with the teachings of the present invention, for forming or otherwise manufacturing the apparatus 175, 185, and provides a useful summary. Beginning with start step 400, the method deposits a plurality of first conductors within a corresponding plurality of channels of a substrate, step 405, such as by printing a conductive ink, followed by curing or partially curing the conductive ink, step 410. A plurality of electronic components, typically suspended in a binder, are then deposited over the plurality of first conductors in the corresponding channels, step 415. The electronic components are then oriented using an applied field, step 420. With the oriented electronic components, the binder is then cured, resulting in stabilized or fixed electronic components in electrical contact at a first end with the plurality of first conductors, step 425. As an option, additional insulating layers may also be applied. Next, a plurality of transmissive second conductors are then deposited and cured, making electrical contact at a second end with the plurality of electronic components, step 430. In exemplary embodiments, such as for an addressable display, the plurality of transmissive second conductors are oriented substantially perpendicular to the plurality of first conductors. Optionally, a plurality of third conductors are then deposited (and cured) over the corresponding plurality of transmissive second conductors, step 435, followed by any deposition (such as through printing) of selected colors or protective coatings, step 440, and the method may end, return step 445.

Although the invention has been described with respect to specific embodiments thereof, these embodiments are merely illustrative and not restrictive of the invention. In the description herein, numerous specific details are provided, such as examples of electronic components, electronic and structural connections, materials, and structural variations, to provide a thorough understanding of embodiments of the present invention. One skilled in the relevant art will recognize, however, that an embodiment of the invention can be practiced without one or more of the specific details, or with other apparatus, systems, assemblies, components, materials, parts, etc. In other instances, well-known structures, materials, or operations are not specifically shown or described in detail to avoid obscuring aspects of embodiments of the present invention. In addition, the various Figures are not drawn to scale and should not be regarded as limiting.

Reference throughout this specification to "one embodiment", "an embodiment", or a specific "embodiment" means that a particular feature, structure, or characteristic described in connection with the embodiment is included in at least one embodiment of the present invention and not necessarily in all embodiments, and further, are not necessarily referring to the same embodiment. Furthermore, the particular features, structures, or characteristics of any specific embodiment of the present invention may be combined in any suitable manner and in any suitable combination with one or more other embodiments, including the use of selected features without corresponding use of other features.

It will also be appreciated that one or more of the elements depicted in the Figures can also be implemented in a more separate or integrated manner, or even removed or rendered inoperable in certain cases, as may be useful in accordance with a particular application. Integrally formed combinations of components are also within the scope of the invention, particularly for embodiments in which a separation or combination of discrete components is unclear or indiscernible. In addition, use of the term "coupled" herein, including in its various forms such as "coupling" or "couplable", means and includes any direct or indirect electrical, structural or magnetic coupling, connection or attachment, or adaptation or capability for such a direct or indirect electrical, structural or magnetic coupling, connection or attachment, including integrally formed components and components which are coupled via or through another component.

As used herein for purposes of the present invention, the term "LED" and its plural form "LEDs" should be understood to include any electroluminescent diode or other type of carrier injection- or junction-based system which is capable of generating radiation in response to an electrical signal, including without limitation, various semiconductor- or carbon-based structures which emit light in response to a current or voltage, light emitting polymers, organic LEDs, and so on, including within the visible spectrum, or other spectra such as ultraviolet or infrared, of any bandwidth, or of any color or color temperature. Similarly, as used herein for purposes of the present invention, the term "photovoltaic diode" and its plural form "photovoltaic diodes" should be understood to include any diode or other type of carrier injection- or junction-based system which is capable of generating an electrical signal or other form of energy in response to incident light, including without limitation, various semiconductor-, polymer-, organic- or other carbon-based structures which emit or generate a current or voltage or other type of power in response to exposure to electromagnetic radiation, including within the visible spectrum, or other spectra such as ultraviolet or infrared, of any bandwidth, or of any color or color temperature.

Furthermore, any signal arrows in the drawings/Figures should be considered only exemplary, and not limiting, unless otherwise specifically noted. Combinations of components of steps will also be considered within the scope of the present invention, particularly where the ability to separate or combine is unclear or foreseeable. The disjunctive term "or", as used herein and throughout the claims that follow, is generally intended to mean "and/or", having both conjunctive and disjunctive meanings (and is not confined to an "exclusive or" meaning), unless otherwise indicated. As used in the description herein and throughout the claims that follow, "a", "an", and "the" include plural references unless the context clearly dictates otherwise. Also as used in the description herein and throughout the claims that follow, the meaning of "in" includes "in" and "on" unless the context clearly dictates otherwise.

## Claims

1. A method of manufacturing an electronic apparatus, the method comprising:
depositing a first conductive medium within a plurality of cavities (105, 205) of a substrate (100, 100A, 100B, 100C, 200) to form a plurality of first conductors (110, 110A, 110B);
depositing a plurality of diodes (120) suspended in a liquid within the plurality of cavities (105, 205), each diode of the plurality of diodes (120) having a first contact (125, 130) and a second contact (130, 125);
orienting the plurality of diodes (120) using an applied field (150); and
depositing a second, optically transmissive conductive medium to form a plurality of second conductors (140) electrically coupled to the second contacts (130, 125) of at least some diodes of the plurality of diodes (120);
**characterized by**:
the liquid being an insulating binder (135);
in the orienting step the at least some diodes of the plurality of diodes (120) being rotated and orientated using an applied magnetic field (150) while the plurality of diodes (120) are suspended in the insulating binder, the orientation of the at least some diodes (120) being to a plane substantially perpendicular to the substrate plane, the first contacts (125, 130) of the at least some diodes being in electrical contact with at least one first conductor of the plurality of first conductors (110, 110A, 110B) and the second contacts (130, 125) of the at least some diodes (120) being rotated away and spaced apart from the substrate plane; and the method further comprises the step of
curing the insulating binder (135) while the at least some diodes are oriented by the applied magnetic field (150) to form a cured insulating binder (135) having a dielectric constant greater than one and at least partially exposing the second contacts (130, 125) of the at least some diodes.

2. The method of claim 1, wherein the curing step further comprises:
bonding the first contacts of the at least some diodes of the plurality of diodes (120) to the plurality of first conductors (110, 110A, 110B) by abutment to or within the plurality of first conductors or by annealing the first contacts of the at least some diodes of the plurality of diodes (120) to the plurality of first conductors (110, 110A, 110B).

3. The method of claim 1, wherein the first conductive medium is a conductive ink and wherein the second conducting medium is an optically transmissive polymer.

4. The method of claim 1, wherein the step of using the applied magnetic field (150) further comprises using an electromagnetic field.

5. The method of claim 1, further comprising:
applying a sonic field subsequent to or during the deposition of the plurality of diodes (120).

6. The method of claim 1, further comprising:
vibrating the substrate subsequent to or during the deposition of the plurality of diodes (120).

7. The method of claim 1, wherein the plurality of cavities (105, 205) are integrally molded in the substrate (100, 100A, 100B, 100C, 200).

8. The method of claim 1, wherein the substrate (100, 100A, 100B, 100C, 200) is embossed.

9. The method of claim 1, wherein the deposition steps further comprise at least one of the following types of deposition: printing, coating, rolling, spraying, layering, sputtering, lamination, screen printing, inkjet printing, electro-optical printing, electroink printing, photoresist printing, thermal printing, laser jet printing, magnetic printing, pad printing, flexographic printing, hybrid offset lithography, Gravure printing, and/or printing.

10. The method of claim 1, wherein the step of depositing the first conductive medium further comprises coating the plurality of cavities (105, 205) with the first conductive medium and removing excess first conductive medium by scraping a surface of the substrate (100, 100A, 100B, 100C, 200) using a doctor blade.

11. The method of claim 1, wherein the step of depositing the plurality of diodes (120) further comprises coating the plurality of cavities (105, 205) with the plurality of diodes (120) suspended in the insulating binder and removing excess plurality of diodes by scraping a surface of the substrate (100, 100A, 100B, 100C, 200) using a doctor blade.

12. The method of claim 1, wherein the plurality of diodes (120) are light emitting diodes, or photovoltaic diodes.

13. The method of claim 1, wherein the plurality of cavities (105, 205) are at least one of the following types of cavities: channels, grooves, or substantially hemispherically-shaped depressions or bores.

14. The method of claim 1, wherein the electronic apparatus is an addressable light emitting diode display, or a lighting apparatus, or a power generating apparatus.

15. The method of claim 1, wherein the first and second contacts (125, 130) of each diode of the plurality of diodes (120) are responsive to be oriented in the applied magnetic field.

## Patentansprüche

1. Verfahren zur Herstellung einer elektronischen Vorrichtung, das Verfahren umfassend:
das Aufbringen eines ersten leitfähigen Mediums innerhalb einer Vielzahl von Hohlräumen (105, 205) eines Substrats (100, 100A, 100B, 100C, 200) zur Bildung einer Vielzahl von ersten Leitern (110, 110A, 110B);
das Aufbringen einer Vielzahl von in einer Flüssigkeit schwimmenden Dioden (120) innerhalb der Vielzahl von Hohlräumen (105, 205), wobei jede Diode aus der Vielzahl von Dioden (120) einen ersten Kontakt (125, 130) sowie einen zweiten Kontakt (130, 125) aufweist;
das Orientieren der Vielzahl von Dioden (120) durch Verwenden eines angelegten Felds (150); und
das Aufbringen eines zweiten, optisch durchlässigen leitfähigen Mediums zur Bildung einer Vielzahl von zweiten Leitern (140), die elektrisch mit den zweiten Kontakten (130, 125) von zumindest einigen Dioden aus der Vielzahl von Dioden (120) gekoppelt sind;
**dadurch gekennzeichnet, dass**:
es sich bei der Flüssigkeit um ein isolierendes Bindemittel (135) handelt;
beim Schritt des Orientierens die mindestens einigen Dioden aus der Vielzahl von Dioden (120) mithilfe eines angelegten magnetischen Felds (130) gedreht und orientiert werden, während die Vielzahl von Dioden (120) in dem isolierenden Bindemittel schwimmen, wobei die Orientierung der mindestens einigen Dioden (120) in einer Ebene erfolgt, die im Wesentlichen senkrecht zur Substrat-Ebene verläuft, die ersten Kontakte (125, 130) der mindestens einigen Dioden elektrischen Kontakt mit mindestens einem ersten Leiter aus der Vielzahl von ersten Leitern (110, 110A, 110B) haben und die zweiten Kontakte (130, 125) der mindestens einigen Dioden (120) von der Substrat-Ebene weg gedreht sind und zu dieser einen Abstand aufweisen; und wobei das Verfahren des Weiteren den folgenden Schritt umfasst:
das Aushärten des isolierenden Bindemittels (135), während die mindestens einigen Dioden durch das angelegte magnetische Feld (150) ausgerichtet sind, um ein ausgehärtetes isolierendes Bindemittel (135) zu bilden, das eine Dielelektrizitätskonstante über eins aufweist und das die zweiten Kontakte (130, 125) der mindestens einigen Dioden zumindest teilweise freilegt.

2. Verfahren gemäß Anspruch 1, wobei der Schritt des Aushärtens des Weiteren umfasst:
das Bonden der ersten Kontakte der mindestens einigen Dioden aus der Vielzahl von Dioden (120) an die Vielzahl der ersten Leiter (110, 110A, 110B) durch Anstoßen an die oder in die Vielzahl von ersten Leitern oder durch Tempern der ersten Kontakte der mindestens einigen Dioden aus der Vielzahl der Dioden (120) an die Vielzahl der ersten Leiter (110, 110A, 110B).

3. Verfahren gemäß Anspruch 1, wobei es sich bei dem ersten leitfähigen Medium um eine leitfähige Farbe handelt und wobei es sich bei dem zweiten leitfähigen Medium um ein optisch durchlässiges Polymer handelt.

4. Verfahren gemäß Anspruch 1, wobei der Schritt des Verwendens des angelegten magnetischen Felds (150) des Weiteren das Verwenden eines elektromagnetischen Felds umfasst.

5. Verfahren gemäß Anspruch 1, des Weiteren umfassend:
das Anlegen eines Schallfelds im Anschluss an das oder während des Aufbringens der Vielzahl von Dioden (120).

6. Verfahren gemäß Anspruch 1, des Weiteren umfassend:
das Vibrieren des Substrats im Anschluss an das oder während des Aufbringens der Vielzahl von Dioden (120).

7. Verfahren gemäß Anspruch 1 wobei die Vielzahl von Hohlräumen (105, 205) als integrale Bestandteile in das Substrat (100, 100A, 100B, 100C, 200) geformt sind.

8. Verfahren gemäß Anspruch 1, wobei das Substrat (100, 100A, 100B, 100C, 200) geprägt ist.

9. Verfahren gemäß Anspruch 1, wobei die Aufbringungsschritte des Weiteren mindestens einen der folgenden Typen von Aufbringung umfassen: Drucken, Beschichten, Walzen, Sprühen, Schichtbilden, Zerstäuben, Laminieren, Siebdrucken, Tintenstrahldrucken, elektrooptisches Drucken, Electrolnk-Drucken, Photolackdrucken, thermisches Drucken, Laserdrucken, Magnetdrucken, Tampondrucken, Flexodrucken, Hybrid-Offsetlithografie, Tiefdrucken und/oder Drucken.

10. Verfahren gemäß Anspruch 1, wobei der Schritt des Aufbringens des ersten leitfähigen Mediums des Weiteren das Beschichten der Vielzahl von Hohlräumen (105, 205) mit dem ersten leitfähigen Medium und das Entfernen von überschüssigen erstem leitfähigen Medium durch Abkratzen einer Oberfläche des Substrats (100, 100A, 100B, 100C, 200) mit einer Schaberklinge umfasst.

11. Verfahren gemäß Anspruch 1, wobei der Schritt des Aufbringens der Vielzahl von Dioden (120) des Weiteren das Beschichten der Vielzahl von Hohlräumen (105, 205) mit der Vielzahl von in dem isolierenden Bindemittel schwimmenden Dioden (120) und das Entfernen der überschüssigen Vielzahl von Dioden durch Abkratzen einer Oberfläche des Substrats (100, 100A, 100B, 100C, 200) mit einer Schaberklinge umfasst.

12. Verfahren gemäß Anspruch 1, wobei es sich bei der Vielzahl von Dioden (120) um Leuchtdioden (LEDs) oder um Photovoltaik-Dioden handelt.

13. Verfahren gemäß Anspruch 1, wobei es sich bei der Vielzahl von Hohlräumen (105, 205) um mindestens einen der folgenden Typen von Hohlräumen handelt: Kanäle, Rinnen oder im Wesentlichen halbkugelförmige Vertiefungen oder Bohrungen.

14. Verfahren gemäß Anspruch 1, wobei es sich bei der elektronischen Vorrichtung um ein adressierbares Leuchtdioden-Display oder eine Beleuchtungsvorrichtung oder eine Energieerzeugungsvorrichtung handelt.

15. Verfahren gemäß Anspruch 1, wobei die ersten und zweiten Kontakte (125, 130) von jeder Diode aus der Vielzahl von Dioden darauf ansprechen, wenn sie in dem angelegten magnetischen Feld ausgerichtet werden.

## Revendications

1. Un procédé de fabrication d'un appareil électronique, le procédé comprenant :
le dépôt d'un premier milieu conducteur à l'intérieur d'une pluralité de cavités (105, 205) d'un substrat (100, 100A, 100B, 100C, 200) de façon à former une pluralité de premiers conducteurs (110, 110A, 110B),
le dépôt d'une pluralité de diodes (120) suspendues dans un liquide à l'intérieur de la pluralité de cavités (105, 205), chaque diode de la pluralité de diodes (120) possédant un premier contact (125, 130) et un deuxième contact (130, 125),
l'orientation de la pluralité de diodes (120) au moyen d'un champ appliqué (150), et
le dépôt d'un deuxième milieu conducteur optiquement transmissif de façon à former une pluralité de deuxièmes conducteurs (140) électriquement couplés aux deuxièmes contacts (130, 125) d'au moins certaines diodes de la pluralité de diodes (120),
**caractérisé en ce que** :
le liquide est un liant isolant (135),
dans l'opération d'orientation, les au moins certaines diodes de la pluralité de diodes (120) sont pivotées et orientées au moyen d'un champ magnétique appliqué (150) pendant que la pluralité de diodes (120) sont suspendues dans le liant isolant, l'orientation des au moins certaines diodes (120) étant dans un plan sensiblement perpendiculaire au plan du substrat, les premiers contacts (125, 130) des au moins certaines diodes étant en contact électrique avec au moins un premier conducteur de la pluralité de premiers conducteurs (110, 110A, 110B) et les deuxièmes contacts (130, 125) des au moins certaines diodes (120) étant éloignés par rotation et espacés du plan du substrat ; et le procédé comprend en outre l'opération de
durcissement du liant isolant (135) pendant que les au moins certaines diodes sont orientées par le champ magnétique appliqué (150) de façon à former un liant isolant durci (135) possédant une constante diélectrique supérieure à un et l'exposition au moins partielle des deuxièmes contacts (130, 125) des au moins certaines diodes.

2. Le procédé selon la Revendication 1, où l'opération de durcissement comprend en outre :
la liaison des premiers contacts des au moins certaines diodes de la pluralité de diodes (120) à la pluralité de premiers conducteurs (110, 110A, 110B) par butée contre ou à l'intérieur de la pluralité de premiers conducteurs ou par recuit des premiers contacts des au moins certaines diodes de la pluralité de diodes (120) à la pluralité de premiers conducteurs (110, 110A, 110B).

3. Le procédé selon la Revendication 1, où le premier milieu conducteur est une encre conductrice et où le deuxième milieu conducteur est un polymère optiquement transmissif.

4. Le procédé selon la Revendication 1, où l'opération d'utilisation du champ magnétique appliqué (150) comprend en outre l'utilisation d'un champ électromagnétique.

5. Le procédé selon la Revendication 1, comprenant en outre:
l'application d'un champ acoustique à la suite de ou au cours du dépôt de la pluralité de diodes (120).

6. Le procédé selon la Revendication 1, comprenant en outre:
la mise en vibration du substrat à la suite de ou au cours du dépôt de la pluralité de diodes (120).

7. Le procédé selon la Revendication 1, où la pluralité de cavités (105, 205) sont intégralement moulées dans le substrat (100, 100A, 100B, 100C, 200).

8. Le procédé selon la Revendication 1, où le substrat (100, 100A, 100B, 100C, 200) est gaufré.

9. Le procédé selon la Revendication 1, où les opérations de dépôt comprennent en outre au moins l'un des types suivants de dépôt : impression, enrobage, roulage, pulvérisation, couchage, pulvérisation cathodique, pelliculage, sérigraphie, impression à jet d'encre, impression électro-optique, impression à l'encre électronique, impression à la résine photosensible, impression thermique, impression par jet laser, impression magnétique, impression au tampon, impression flexographique, lithographie offset hybride, héliogravure et/ou impression.

10. Le procédé selon la Revendication 1, où l'opération de dépôt du premier milieu conducteur comprend en outre l'enrobage de la pluralité de cavités (105, 205) avec le premier milieu conducteur et le retrait du premier milieu conducteur en excès par le raclage d'une surface du substrat (100, 100A, 100B, 100C, 200) au moyen d'un racloir.

11. Le procédé selon la Revendication 1, où l'opération de dépôt de la pluralité de diodes (120) comprend en outre l'enrobage de la pluralité de cavités (105, 205) avec la pluralité de diodes (120) suspendues dans le liant isolant et le retrait de pluralité de diodes en excès par le raclage d'une surface du substrat (100, 100A, 100B, 100C, 200) au moyen d'un racloir.

12. Le procédé selon la Revendication 1, où la pluralité de diodes (120) sont des diodes électroluminescentes ou des diodes photovoltaïques.

13. Le procédé selon la Revendication 1, où la pluralité de cavités (105, 205) sont au moins de l'un des types de cavités suivants : canaux, rainures ou dépressions ou trous de forme sensiblement hémisphérique.

14. Le procédé selon la Revendication 1, où l'appareil électronique est un dispositif d'affichage à diodes électroluminescentes adressables ou un appareil d'éclairage ou un appareil de génération de courant.

15. Le procédé selon la Revendication 1, où les premier et deuxième contacts (125, 130) de chaque diode de la pluralité de diodes (120) sont réactifs de façon à être orientés dans le champ magnétique appliqué.
